(19) Europäisches Patentamt
European Patent Office
Office européen des brevets

(11) **EP 4 345 064 A1**

(12) **EUROPEAN PATENT APPLICATION**

(43) Date of publication:
**03.04.2024 Bulletin 2024/14**

(21) Application number: **23192538.9**

(22) Date of filing: **22.08.2023**

(51) International Patent Classification (IPC):
**C01B 32/956** (2017.01)   **C01B 32/97** (2017.01)

(52) Cooperative Patent Classification (CPC):
**C01B 32/956;** C01B 32/97; C01P 2004/32;
C01P 2004/51; C01P 2004/61; C01P 2006/11

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **22.08.2022   KR 20220104819**

(71) Applicant: SENIC Inc.
**Seobuk-gu**
**Cheonan-si, Chungcheongnam-do 31040 (KR)**

(72) Inventors:
• **PARK, Jong Hwi**
  **16278 Suwon-si, Gyeonggi-do (KR)**
• **KYUN, Myung Ok**
  **16327 Suwon-si, Gyeonggi-do (KR)**

(74) Representative: **Isarpatent**
**Patent- und Rechtsanwälte**
**Barth Hassa Peckmann & Partner mbB**
**Friedrichstraße 31**
**80801 München (DE)**

(54) **SILICON CARBIDE POWDER**

(57)    A silicon carbide powder having silicon carbide particles including carbon and silicon, wherein a mass ratio of silicon carbide particles having a particle diameter of less than 50 $\mu$m after sonication is 10 Wt% or less.

FIG. 1

```
CRUSH SILICON CARBIDE RAW MATERIAL          — S10
REMOVE CARBON-BASED MATERIAL                — S20
PULVERIZE SILICON CARBIDE RAW MATERIAL      — S30
PHYSICALLY PROCESS SILICON CARBIDE RAW MATERIAL — S40
WET-ETCH SILICON CARBIDE RAW MATERIAL       — S50
DRY-ETCH SILICON CARBIDE RAW MATERIAL       — S60
WASH SILICON CARBIDE RAW MATERIAL           — S70
CLASSIFY SILICON CARBIDE RAW MATERIAL       — S80
```

EP 4 345 064 A1

**Description**

Technical Field

Variousembodiments of the present disclosure relate to a silicon carbide powder, a method for manufacturing the same, and a method of manufacturing a silicon carbide ingot.

Background Art

Silicon carbide (SiC) has excellent heat resistance and mechanical strength, is highly resistant to radiation, and can be used even to produce large-diameter substrates. In addition, silicon carbinde has excellent physical strength and chemical resistance, a large energy band gap, and a large electron saturation drift rate and pressure resistance. Accordingly, silicon carbide is widely used in abrasives, bearings, fireproof plates, and the like as well as semiconductor devices that require high power, high efficiency, high voltage resistance, and high capacity.

Silicon carbide is manufactured through various methods such as heat treatment or electrification of carbon raw materials such as silicon carbide waste. Examples of conventional methods include the Acheson method, a reactive sintering method, an atmospheric pressure sintering method, and a chemical vapor deposition (CVD) method. In these methods, carbon raw materials remain. These residues act as impurities and may deteriorate the thermal, electrical, and mechanical properties of silicon carbide.

For example, Japanese Patent Publication No. 2002-326876 discloses a method of reacting a silicon carbide precursor, which has undergone a heat treatment process, at a high temperature under an inert gas condition such as argon (Ar) to polymerize or cross-link a silicon source and a carbon source. However, this process has problems in that the manufacturing cost is high and the size of the powder is not uniform due to heat treatment at a high temperature of 1,800 °C to 2,100 °C under a vacuum or inert gas condition.

Moreover, wafers used in the solar cell and semiconductor industries are manufactured by growing from silicon ingots in a crucible made of graphite or the like and, during this manufacturing process, a significant amount of silicon carbide waste, adsorbed on the inner wall of the crucible, as well as a waste slurry containing silicon carbide is generated. However, landfill disposal of such waste has caused environmental problems which can result in high disposal costs.

SUMMARY

In one embodiment of the present invention, there is provided a silicon carbide powder capable of improving the growth rate of a silicon carbide ingot and lowering the number of defects in a silicon carbide wafer, a method for manufacturing the silicon carbide powder and a method of manufacturing a silicon carbide wafer using the silicon carbide powder.

In accordance with one aspect of the present invention, there is provided a silicon carbide powder, including silicon carbide particles including carbon and silicon, wherein a mass ratio of silicon carbide particles having a particle diameter of less than 50 $\mu$m after sonication is 10 wt% or less.

In the silicon carbide powder according to another embodiment, a mass ratio of silicon carbide particles having a particle diameter of less than 10 $\mu$m after sonication may be 3 wt% or less.

In the silicon carbide powder according to another embodiment, a mass ratio of silicon carbide particles having a particle diameter of less than 5 $\mu$m after sonication may be 2 wt% or less.

In the silicon carbide powder according to another embodiment, the silicon carbide powder may have an average particle diameter (D50) of 100 $\mu$m to 5000 $\mu$m.

In the silicon carbide powder according to another embodiment, a particle circularity measured through 2D image analysis may be 0.4 to 0.9.

In the silicon carbide powder according to another embodiment, a particle convexity measured through the 2D image analysis may be 0.8 to 0.99.

In the silicon carbide powder according to another embodiment, the silicon carbide powder may have a repose angle of 30° to 45°.

In the silicon carbide powder according to anotehr embodiment the silicon carbide powder may have a tap density of 1000 kg/m$^3$ to 2000 kg/m$^3$.

In accordance with another aspect of the present invention, there is provided a method of manufacturing a silicon carbide powder, the method including: providing a raw material including silicon carbide; powdering the raw material; and physically processing the powdered raw material, wherein a mass ratio of silicon carbide particles having a particle diameter of less than 50 $\mu$m after sonication is 10 wt% or less.

In another embodiment, the physically processing of the powdered raw material may include separating silicon carbide particles having a particle diameter of less than 50 $\mu$m.

In accordance with yet another aspect of the present invention, there is provided a method of manufacturing a silicon carbide wafer, the method including: preparing a silicon carbide powder including silicon carbide particles that includes carbon and silicon, wherein a mass ratio of silicon carbide particles having a particle diameter of less than 50 μm after sonication is 10 wt% or less; growing a silicon carbide ingot using the silicon carbide powder; and processing the silicon carbide ingot.

Description of Drawings

FIG. 1 is a flowchart illustrating a manufacturing process of a silicon carbide powder according to one embodiment.
FIG. 2 is a flowchart illustrating a manufacturing process of a silicon carbide powder according to another embodiment.
FIG. 3 is a flowchart illustrating a manufacturing process of a silicon carbide powder according to another embodiment.
FIG. 4 is a flowchart illustrating a manufacturing process of a silicon carbide powder according to another embodiment.
FIG. 5 is a flowchart illustrating a manufacturing process of a silicon carbide powder according to another embodiment.
FIG. 6 is a flowchart illustrating a manufacturing process of a silicon carbide powder according to another embodiment.
FIG. 7 is a sectional view illustrating a process of growing a silicon carbide ingot.

Detailed Description

Hereinafter, the invention will be described in detail through the described embodiments. The described embodiments are not limited to contents disclosed below and may be modified in various forms.
In the present specification, unless otherwise specified, when a part "comprises" a certain component, it means that other components may be further included, rather than excluding other components.
It should be understood that all numbers and expressions indicating the amounts of components, reaction conditions, etc. described in this specification are modified by the term "about" in all cases unless otherwise specified. The term "about" refers to variations in the magnitude of the quantity described of +/- 2%.
It should be understood that, for the ranges described, the present disclosure includes all intermediate values and sub-ranges within the specified range described.
In one embodiment, there is provided a silicon carbide powder including carbon and silicon wherein a mass ratio of silicon carbide particles having a particle diameter of less than 50 μm after sonication is 10 wt% or less. In addition, a mass ratio of silicon carbide particles having a particle diameter of less than 10 μm after sonication in the silicon carbide powder according to the embodiment can be about 3 wt% or less. In addition, a mass ratio of silicon carbide particles having a particle diameter of less than 5 μm after sonication in the silicon carbide powder according to the embodiment can be 2 wt% or less.
Accordingly, the silicon carbide powder according to one embodiment can be filled into a crucible for manufacture a silicon carbide ingot and a silicon carbide wafer. In addition, since the silicon carbide powder can have particle diameter distributions noted above after appropriate sonication, it can have an appropriate porosity when filled in the crucible.
In addition, since the silicon carbide powder has the particle diameter distributions after the sonications described above, it is possible to prevent fine particles from being attached to a seed tablet when the silicon carbide ingot is grown. Accordingly, the silicon carbide powder can prevent defects from occurring in the silicon carbide ingot.
That is, since the silicon carbide powder hardly contains fine cracks, no fine powder is generated from the silicon carbide powder even if a growth temperature is elevated when the silicon carbide ingot is grown. Accordingly, the silicon carbide powder according to the embodiment can prevent defects caused by fine powder in a silicon carbide wafer according to an embodiment.
That is, since the silicon carbide powder according to the embodiment hardly contains latent fine powder, defects caused by fine powder in a growth process can be prevented.
Below, a method of manufacturing a silicon carbide powder according to one embodiment includes an operation of preparing a silicon carbide raw material.
The silicon carbide raw material includes silicon carbide. The silicon carbide raw material may include α-phase silicon carbide and/or β-phase silicon carbide. In addition, the silicon carbide raw material may include a silicon carbide monocrystal and/or a silicon carbide polycrystal.
In addition, the silicon carbide raw material may further include unwanted impurities in addition to silicon carbide.
The silicon carbide raw material may further include a carbon-based material such as graphite as an impurity. The carbon-based material may be derived from a graphite crucible and the like. The carbon-based material may be included in the silicon carbide raw material in a content of about 5 % by weight to about 50 % by weight. The carbon-based material may be included in a content of about 50 % by weight or less in the silicon carbide raw material. The carbon-based material may be included in a content of about 45 % by weight or less in the silicon carbide raw material.

The carbon-based material may be included in a content ranging from about 40 % by weight or less in the silicon carbide raw material. The carbon-based material may be included in a content ranging from about 1 % by weight to about 50 % by weight in the silicon carbide raw material. The carbon-based material may be included in a content ranging from about 5 % by weight to about 45 % by weight in the silicon carbide raw material. The carbon-based material may be included in a content ranging from about 10 % by weight to about 40 % by weight in the silicon carbide raw material. The carbon-based material may be included in a content ranging from about 10 % by weight to about 35 % by weight in the silicon carbide raw material. The carbon-based material may be included in a content ranging from about 10 % by weight to about 30 % by weight in the silicon carbide raw material. The carbon-based material may be included in a content ranging from about 10 % by weight to about 20 % by weight in the silicon carbide raw material.

The silicon carbide raw material may further include free silicon as an impurity. Free silicon may be derived from a silicon substrate and/or a silicon component, etc. The silicon component may be a component applied to a semiconductor equipment such as a focus ring. Free silicon may be included in a content ranging from about 0.01 % by weight to about 10 % by weight in the silicon carbide raw material.

The silicon carbide raw material may further include a metallic impurity. The metallic impurity may be at least one or more selected from the group consisting of lithium, boron, sodium, aluminum, phosphorus, potassium, calcium, titanium, vanadium, chromium, manganese, iron, nickel, copper, zinc, strontium, zirconium, molybdenum, tin, barium, tungsten, and lead.

The content of the metallic impurity may range from about 0.1 ppm to 13 ppm. The content of the metallic impurity may range from about 0.3 ppm to 12 ppm. The content of the metallic impurity may range from about 0.5 ppm to 8 ppm. The content of the metallic impurity may range from about 0.8 ppm to 10 ppm. The content of the metallic impurity may range from about 1 ppm to 6 ppm. The content of the metallic impurity may range from about 0.1 ppm to 5 ppm. The content of the metallic impurity may range from about 0.5 ppm to 3 ppm. The content of the metallic impurity may range from about 0.5 ppm to 2 ppm.

The silicon carbide raw material may further include a non-metallic impurity. The non-metallic impurity may be one or more selected from the group consisting of fluorine, nitrogen, chlorine, and phosphorus.

The content of the non-metallic impurity may range from about 0.01 ppm to 13 ppm. The content of the non-metallic impurity may range from about 0.03 ppm to 12 ppm. The content of the non-metallic impurity may range from about 0.05 ppm to 8 ppm. The content of the non-metallic impurity may range from about 0.08 ppm to 10 ppm. The content of the non-metallic impurity may range from about 0.1 ppm to 6 ppm. The content of the non-metallic impurity may range from about 0.1 ppm to 5 ppm. The content of the non-metallic impurity may range from about 0.5 ppm to 3 ppm. The content of the non-metallic impurity may range from about 0.5 ppm to 2 ppm.

The silicon carbide raw material may have a lump shape. The silicon carbide raw material may have a plate shape. The silicon carbide raw material may have a rod shape.

The silicon carbide raw material may include about 30 % by weight or more of particles having diameter of about 1 mm or more. The silicon carbide raw material may include about 50 % by weight or more of particles having diameter of about 1 mm or more. The silicon carbide raw material may include about 70 % by weight or more of particles having diameter of about 1 mm or more.

The silicon carbide raw material may include about 30 % by weight or more of particles having diameter of about 10 mm or more. The silicon carbide raw material may include about 50 % by weight or more of particles having diameter of about 10 mm or more. The silicon carbide raw material may include about 70 % by weight or more of particles having diameter of about 10 mm or more.

Here, a sphere having the same volume as the volume of the particle is assumed, and the diameter of the sphere is defined as the particle diameter.

In addition, the silicon carbide raw material may be derived from a substrate including silicon carbide. The silicon carbide raw material may be derived from a wafer entirely including silicon carbide. The silicon carbide raw material may be derived from a silicon carbide layer, deposited on a substrate, such as silicon.

In addition, the silicon carbide raw material may be derived from a silicon carbide monocrystal ingot. The silicon carbide monocrystal ingot may be discarded due to defects occurring during the manufacturing process. Alternatively, the silicon carbide raw material may be derived from a silicon carbide polycrystal.

The silicon carbide raw material may be derived from a silicon carbide sintered body. The silicon carbide sintered body may be formed by sintering a silicon carbide powder. The silicon carbide sintered body may be a component included in semiconductor manufacturing equipment.

The silicon carbide raw material may be derived from a graphite component including a silicon carbide layer. The graphite component may include a crucible for forming a silicon carbide ingot, etc.

The silicon carbide raw material may be derived from a component of a semiconductor equipment including a silicon carbide layer. The silicon carbide layer may be formed by depositing silicon carbide on the surface on a silicon component, etc. by a chemical vapor deposition (CVD) process.

The method of manufacturing a silicon carbide powder according to one embodiment may include an operation of cutting the silicon carbide raw material.

When the silicon carbide raw material is too large, the silicon carbide raw material may be cut by a wire saw or bar cutting which includes diamond abrasive grains, etc. The silicon carbide raw material may be cut to a length of 150 mm.

The method of manufacturing a silicon carbide powder according to another embodiment may include an operation of crushing a silicon carbide raw material.

The operation of crushing a silicon carbide raw material may be a process of breaking the silicon carbide raw material into particles having an average particle diameter of about 100 mm or less. By the crushing process, the silicon carbide raw material may be split into particles having an average particle diameter of about 80 mm or less. By the crushing process, the silicon carbide raw material may be split into particles having an average particle diameter of about 60 mm or less. By the crushing process, the silicon carbide raw material may be split into particles having an average particle diameter of about 50 mm or less. By the crushing process, the silicon carbide raw material may be split into particles having an average particle diameter of about 0.1 mm to about 50 mm. By the crushing process, the silicon carbide raw material may be split into particles having an average particle diameter of about 1 mm to about 40 mm.

In the crushing process, a jaw crusher, a cone crusher, or a gyratory crusher may be used.

The jaw crusher includes a pair of compression plates, and the silicon carbide raw material is inserted between the compression plates. The silicon carbide raw material is crushed by the pressure applied through the compression plates, and the crushed silicon carbide raw material may be discharged downward by magnetic gravity.

Each of the compression plates may include at least one of steel, stainless steel, manganese-added steel, chromium-added steel, nickel-added steel, molybdenum-added steel, nitrogen-added steel, and tungsten carbide. A portion of the compression plate in direct contact with the silicon carbide raw material may be made of at least one or more of steel, stainless steel, manganese-added steel, chromium-added steel, nickel-added steel, molybdenum-added steel, nitrogen-added steel, and tungsten carbide. A portion of the compression plate in direct contact with the silicon carbide raw material may be coated with tungsten carbide.

The gyratory crusher includes a crushing head and a crushing bowl accommodating the crushing head. The crushing head has a truncated cone shape, and the crushing head is mounted on a shaft. An upper end of the crushing head is fixed to a flexible bearing, and a lower end of the crushing head is driven eccentrically to draw a circle. The crushing action is made around the entire cone, and the maximum movement is made at the bottom. Accordingly, since the crushing of the gyratory crusher continues to operate, the gyratory crusher has less stress fluctuation and lower power consumption than the jaw crusher.

Like the jaw crusher, the crushing head and the crushing bowl which are parts in direct contact with the silicon carbide raw material may include at least one or more of steel, stainless steel, manganese-added steel, chromium-added steel, nickel-added steel, molybdenum-added steel, nitrogen-added steel, and tungsten carbide. Portions of the crushing head and the crushing bowl which are in direct contact with the silicon carbide raw material may be made of at least one or more of steel, stainless steel, manganese-added steel, chromium-added steel, nickel-added steel, molybdenum-added steel, nitrogen-added steel, and tungsten carbide. Portions of the crushing head and the crushing bowl in direct contact with the silicon carbide raw material may be coated with tungsten carbide.

The cone crusher is a device for crushing the silicon carbide raw material by both an impact force and compression force. The cone crusher has a similar structure and crushing motion to the gyratory crusher. However, the cone crusher may have shorter cones. The cone crusher includes an umbrella-shaped cone mantle head mounted on a vertical central axis. By the eccentric motion of the cone mantle head, the silicon carbide raw material is compressed into a cone cave bowl, and as it goes down, the silicon carbide raw material is crushed.

Like the jaw crusher, the cone mantle head and the cone cave bowl whish are parts in direct contact with the silicon carbide raw material may include at least one or more of steel, stainless steel, manganese-added steel, chromium-added steel, nickel-added steel, molybdenum-added steel, nitrogen-added steel, and tungsten carbide. Portions of the cone mantle head and the cone cave bowl in direct contact with the silicon carbide raw material may be made of at least one or more of steel, stainless steel, manganese-added steel, chromium-added steel, nickel-added steel, molybdenum-added steel, nitrogen-added steel, and tungsten carbide. Portion of the cone mantle head and the cone cave bowl in direct contact with the silicon carbide raw material may be coated with tungsten carbide.

The method of manufacturing a silicon carbide powder according to another embodiment may include an operation of pulverizing a silicon carbide raw material.

The operation of pulverizing a silicon carbide raw material may include a process of breaking the silicon carbide raw material into particles having a diameter of about 30 mm or less. By the pulverization process, the silicon carbide raw material may be split into particles having an average particle diameter of about 20 mm or less. By the pulverization process, the silicon carbide raw material may be split into particles having an average particle diameter of about 15 mm or less. By the pulverization process, the silicon carbide raw material may be split into particles having an average particle diameter of about 10 mm or less. By the pulverization process, the silicon carbide raw material may be split into particles having an average particle diameter ranging from about 0.1 mm to about 10 mm. By the pulverization process,

**EP 4 345 064 A1**

the silicon carbide raw material may be split into particles having an average particle diameter ranging from about 0.1 mm to about 8 mm. By the pulverization process, the silicon carbide raw material may be split into particles having an average particle diameter ranging from about 0.01 mm to about 6 mm.

In the pulverization process, a ball mill, a hammer crusher, a jet mill, or the like may be used.

The ball mill may include a metal cylinder and a ball. The ball and the silicon carbide raw material are placed in the metal cylinder. When the metal cylinder rotates, the ball and the silicon carbide raw material can be rotated by the friction between the ball and the silicon carbide raw material and the centrifugal force within the metal cylinder. At this time, the ball and the silicon carbide raw material rise to a certain height in the cylinder, and then fall, and the silicon carbide raw material is pulverized and polished. Depending on the rotational speed of the cylinder, the inner diameter of the cylinder, the size of the ball, the material of the ball, and the time of the pulverization process, the silicon carbide raw material may be split into particles having a small diameter.

The metal cylinder and the ball which are parts in direct contact with the silicon carbide raw material may include at least one or more of steel, stainless steel, manganese-added steel, chromium-added steel, nickel-added steel, molybdenum-added steel, nitrogen-added steel, and tungsten carbide. Portion of the metal cylinder and the ball in direct contact with the silicon carbide raw material may be made of at least one or more of steel, stainless steel, manganese-added steel, chromium-added steel, nickel-added steel, molybdenum-added steel, nitrogen-added steel, and tungsten carbide. Portions of the metal cylinder and the ball in direct contact with the silicon carbide raw material may be coated with tungsten carbide.

The hammer crusher includes a chamber and multiple hammers. The hammers are mounted on a rotating body placed within the chamber. The hammers rotate within the chamber, and the hammers impact on the silicon carbide raw material. Accordingly, the silicon carbide raw material may be split into particles having a small diameter.

The chamber and the hammers which are parts in direct contact with the silicon carbide raw material may include at least one or more of steel, stainless steel, manganese-added steel, chromium-added steel, nickel-added steel, molybdenum-added steel, nitrogen-added steel, and tungsten carbide. Portions of the chamber and the hammers in direct contact with the silicon carbide raw material may be made of at least one or more of steel, stainless steel, manganese-added steel, chromium-added steel, nickel-added steel, molybdenum-added steel, nitrogen-added steel, and tungsten carbide. Portions of the chamber and the hammers in direct contact with the silicon carbide raw material may be coated with tungsten carbide.

The jet mill includes a chamber and a nozzle. The jet mill pulverizes the silicon carbide raw material by mutually colliding silicon carbide raw materials with each other under the energy of injection from the nozzle by the pressure of a fluid. The silicon carbide raw material is pulverized in the chamber until the particle size thereof reaches a desired size. In addition, the particles subjected to the pulverization process are collected through a classification chamber from the jet mill chamber. Since the jet mill pulverizes the silicon carbide raw material by mutual collision of the silicon carbide raw material by the pressure of fluid, the contamination of the silicon carbide raw material by direct contact with other non-silicon carbide devices may be minimized.

The chamber which is a part in direct contact with the silicon carbide raw material may include at least one or more of steel, stainless steel, manganese-added steel, chromium-added steel, nickel-added steel, molybdenum-added steel, nitrogen-added steel, and tungsten carbide. A portion of the chamber which is in direct contact with the silicon carbide raw material may be made of at least one or more of steel, stainless steel, manganese-added steel, chromium-added steel, nickel-added steel, molybdenum-added steel, nitrogen-added steel, and tungsten carbide. A portion of the chamber which is in direct contact with the silicon carbide raw material may be coated with tungsten carbide.

The average particle diameter (D50) of the crushed particles may range from about 1 mm to about 15 mm, and the average particle diameter (D50) of the crushed particles may range from about 100 $\mu$m to about 3 mm. The average particle diameter (D50) of the crushed particles may range from about 3 mm to about 10 mm, and the average particle diameter (D50) of the crushed particles may range from about 100 $\mu$m to about 1 mm. The average particle diameter (D50) of the crushed particles may range from about 1 mm to about 3 mm, and the average particle diameter (D50) of the crushed particles may range from about 300 $\mu$m to about 0.8 mm. The average particle diameter (D50) of the crushed particles may range from about 7 mm to about 13 mm, and the average particle diameter (D50) of the crushed particles may range from about 500 $\mu$m to about 1.5 mm. The average particle diameter (D50) of the crushed particles may range from about 1 mm to about 3 mm, and the average particle diameter (D50) of the crushed particles may range from about 100 $\mu$m to about 800 $\mu$m. The average particle diameter (D50) of the crushed particles may range from about 6 mm to about 10 mm, and the average particle diameter (D50) of the crushed particles may range from about 1 mm to about 3 mm. The average particle diameter (D50) of the crushed particles may range from about 4 mm to about 8 mm, and the average particle diameter (D50) of the crushed particles may range from about 800 $\mu$m to about 2 mm. Since the crushing process and the pulverizing process are carried out to have an average particle diameter (D50) within the above range(s), the silicon carbide powder according to one embodiment may be manufactured to have a desired particle diameter and shape.

The pulverization process may be a ball mill process. In the ball mill process, the diameter of a ball may be about 5 mm to about 50 mm. The diameter of the ball may be about 10 mm to about 40 mm.

In the ball mill process, the rotation speed of a cylinder may be about 10 rpm to about 40 rpm. In the ball mill process, the rotation speed of the cylinder may be about 15 rpm to about 35 rpm.

In the ball mill process, a steel ball may be used. The ball mill process may be carried out for about 10 minutes to about 30 minutes.

To appropriately control the particle size and shape of the silicon carbide powder according to one embodiment, a ball diameter and cylinder rotation speed in the ball mill process and the time of the ball mill process may be controlled appropriately.

The method of manufacturing a silicon carbide powder according to another embodiment may further include an operation of removing iron by application of a magnetic force.

The operation of removing an iron component may be an operation of removing iron adsorbed to the silicon carbide raw material in the crushing and pulverizing operations.

In the operation of removing an iron component, a rotary metal detector may be used to remove the iron.

A rotation speed of the rotary metal detector may be about 100 rpm to about 800 rpm, and an output of an electromagnet included in the rotary metal detector may be about 0.5 kW to about 3kW. In addition, a rotation speed of the rotary metal detector may be about 800 rpm to about 1700 rpm, and an output of an electromagnet included in the rotary metal detector may be about 3 kW to about 5kW.

The content of iron contained in the silicon carbide raw material from which iron has been removed may be about 1 ppm or less. The content of iron contained in the silicon carbide raw material from which iron has been removed about 0.5 ppm or less. The content of iron contained in the silicon carbide raw material from which iron has been removed may be about 0.3 ppm or less. The content of iron contained in the silicon carbide raw material from which iron has been removed may be about 0.1 ppm or less.

The method of manufacturing a silicon carbide powder according to another embodiment includes an operation of removing the carbon-based material.

The operation of removing the carbon-based material may include an operation of physically removing the carbon-based material.

The operation of physically removing the carbon-based material may include a steel cut wire shot process. A wire used for the steel cut wire shot may be made of one or more of carbon steel, stainless steel, aluminum, zinc, nickel, copper, or an alloy thereof, but the present disclosure is not limited thereto. In addition, the diameter of the wire may be about 0.2 mm to about 0.8 mm. The diameter of the wire may be about 0.4 mm to about 0.6 mm.

A rotation speed of the wire may be about 1000 rpm to about 5000 rpm.

In addition, the operation of physically removing the carbon-based material may include a blasting process such as sand blasting or short blasting. The blasting process may be a process of spraying fine particles on the carbon-based material such as graphite to remove the carbon-based material. That is, since the carbon-based material has a lower hardness than the silicon carbide, it can be removed by fine particles sprayed with an appropriate pressure.

In addition, the operation of physically removing the carbon-based material may include a separation process using the density difference and using centrifugation. The crushed and/or pulverized silicon carbide raw material may be separated by the density difference between the carbon-based material and the silicon carbide. That is, since the density of silicon carbide is higher than the density of graphite, the carbon-based material may be removed by density gradient centrifugation, etc.

After the operation of physically removing the carbon-based material, the content of the carbon-based material included in the raw material may be about 5 % by weight or less. After the operation of removing the carbon-based material, the content of the carbon-based material included in the raw material may be about 3 % by weight or less. After the operation of removing the carbon-based material, the content of the carbon-based material included in the raw material may be about 1 % by weight or less.

In addition, the operation of removing the carbon-based material includes an operation of chemically removing the carbon-based material.

The operation of chemically removing the carbon-based material includes an operation of oxidizing the carbon-based material.

After the carbon-based material contained in the raw material is sufficiently removed, the raw material is heat-treated in an oxygen or atmospheric atmosphere. At this time, the oxidative heat treatment temperature may be about 1000 °C to about 1200 °C. The heat treatment time may be about 12 hours to about 48 hours.

Since the raw material is heat-treated in the above time and temperature ranges, the carbon-based material contained in the raw material may be effectively removed. In addition, since the raw material is heat-treated in the above time and temperature ranges, the generation of by-products such as silicon oxide in the raw material may be minimized.

The method of manufacturing a silicon carbide powder according to another embodiment includes an operation of classifying the silicon carbide raw material. In the classifying operation, the silicon carbide raw material granulated through the crushing process and the pulverizing process may be classified.

The granulated silicon carbide raw material may be classified by a mesh of a desired size.

The classifying operation may be performed using a twist screen that is a vibrating classifying device.

The twist screen may include a silicon material-made tapping ball having a diameter of 10 mm to 80 mm, 15 mm to 70 mm, or 20 mm to 60 mm. Using the twist screen, the classifying operation may be performed for about 10 minutes to about 100 minutes under a vibration condition of about 1000 times/minute to about 3000 times/minute.

The granulated silicon carbide raw material may be fed into the twist screen at a constant speed.

The particle diameter (D50) of the granulated silicon carbide raw material may range fromabout 10 $\mu$m to about 10000 $\mu$m. The particle diameter (D50) of the granulated silicon carbide raw material may range from about 100 $\mu$ ill to about 6000 $\mu$m. The particle diameter (D50) of the granulated silicon carbide raw material may range from about 60 $\mu$m to about 5000 $\mu$m. The particle diameter (D50) of the granulated silicon carbide raw material may range from about 100 $\mu$m to about 4000 $\mu$m. The particle diameter (D50) of the granulated silicon carbide raw material may range from about 150 $\mu$m to about 400 $\mu$m. The particle diameter (D50) of the granulated silicon carbide raw material may range from about 300 $\mu$m to about 800 $\mu$m. The particle diameter (D50) of the granulated silicon carbide raw material may range from about 500 $\mu$m to about 1000 $\mu$m. The particle diameter (D50) of the granulated silicon carbide raw material may range from about 700 $\mu$m to about 2000 $\mu$m. The particle diameter (D50) of the granulated silicon carbide raw material may range from about 1000 $\mu$m to about 3000 $\mu$m.

The method of manufacturing a silicon carbide powder according to another embodiment may include an operation of wet etching the silicon carbide raw material.

The wet etching operation is carried out by an etchant. The silicon carbide raw material that has undergone the crushing and pulverizing processes may be subjected to the wet etching operation.

The etchant may include water and an acid. The acid may be at least one or more selected from the group consisting of hydrofluoric acid, nitric acid, hydrochloric acid, and sulfuric acid.

The etchant may include deionized water, hydrofluoric acid, and nitric acid.

The hydrofluoric acid may be included in a content of about 10 parts by weight to about 50 parts by weight based on 100 parts by weight of the deionized water in the etchant. The hydrofluoric acid may be included in a content of about 15 parts by weight to about 45 parts by weight based on 100 parts by weight of the deionized water in the etchant. The hydrofluoric acid may be included in a content of about 20 parts by weight to about 40 parts by weight based on 100 parts by weight of the deionized water in the etchant.

The nitric acid may be included in a content of about 10 parts by weight to about 50 parts by weight based on 100 parts by weight of the deionized water in the etchant. The nitric acid may be included in a content of about 15 parts by weight to about 45 parts by weight based on 100 parts by weight of the deionized water in the etchant. The nitric acid may be included in a content of about 20 parts by weight to about 40 parts by weight based on 100 parts by weight of the deionized water in the etchant.

The etchant may be filled into an etch vessel. Here, the etchant may be filled in an amount of about 10 vol% to about 20 vol% based on the total volume of the etch vessel in the etch vessel. The etchant may be filled in an amount of about 12 vol% to about 18 vol% based on the total volume of the etch vessel in the etch vessel. In addition, the silicon carbide raw material may be filled in an amount of about 10 vol% to about 30 vol% based on the total volume of the etch vessel in the etch vessel. The silicon carbide raw material may be filled in an amount of about 15 vol% to about 25 vol% based on the total volume of the etch vessel in the etch vessel.

The silicon carbide raw material may be wet-etched by the etchant. That is, the surface of the silicon carbide raw material may be etched by the etchant, and impurities remaining on the surface of the silicon carbide raw material may be removed by the etchant.

The wet etching operation may be carried out according to the following processes.

First, the etch vessel and the silicon carbide raw material may be dried. The etch vessel and the silicon carbide raw material may be dried with hot air at about 50 °C to about 150 °C for about 10 minutes to about 1 hour.

Next, the silicon carbide raw material is placed in the etch vessel.

Next, the etchant is fed into the etch vessel in which the silicon carbide raw material has been placed.

A process of feeding the etchant may be as follows.

First, deionized water is fed into the etch vessel in which the silicon carbide raw material has been placed.

Next, hydrofluoric acid is fed into the etch vessel into which the deionized water has been fed.

Next, nitric acid is fed into the etch vessel into which the hydrofluoric acid has been fed.

Next, the etch vessel into which the etchant has been fed is sealed by a lid, the silicon carbide raw material and etchant contained in the etch vessel are stirred at a speed of about 50 rpm to about 500 rpm. The stirring time may be about 30 minutes to about 2 hours.

Next, the etchant is drained, and the silicon carbide raw material subjected to the wet etching process is precipitated several times in deionized water and neutralized. At this time, after precipitation, the neutralization process of the silicon carbide raw material that has undergone the wet etching process may be completed based on the content and/or pH of hydrofluoric acid contained in the drained wastewater. When the pH of the wastewater is 6.8 to 7.2, the neutralization process may be finished.

The method of manufacturing a silicon carbide powder according to another embodiment may include an operation of dry etching the silicon carbide raw material.

The dry etching process may be performed by spraying an etching gas onto the silicon carbide raw material.

The etching gas may include a chlorine gas. The etching gas may further include an inert gas such as argon as a carrier gas.

The dry etching process may be carried out as follows.

First, a dry etching furnace is prepared. The dry etching furnace may be made of graphite and may be heated to a temperature of about 2000 °C or more. The dry etching furnace is sealed against the outside, and the inside of the dry etching furnace may be depressurized up to about 5 Torr or less.

The silicon carbide raw material is placed in the dry etching furnace.

Next, the dry etching furnace is heated up to a temperature of about 1800 °C to about 2200 °C.

Next, the inside of the dry etching furnace is depressurized to a pressure of about 1 Torr to about 30 Torr. The inside of the dry etching furnace is depressurized to a pressure of about 1 Torr to about 10 Torr. The inside of the dry etching furnace is depressurized to a pressure of about 1 Torr to about 8 Torr.

Next, the etching gas is fed into the dry etching furnace. The etching gas may be convected in the dry etching furnace by a temperature difference between the lower portion and the upper portion of the dry etching furnace. That is, the temperature of the lower portion of the dry etching furnace is about 50 °C to about 100 °C higher than the temperature of the upper portion of the dry etching furnace, so that the etching gas at the lower portion of the dry etching furnace moves to the upper portion of the dry etching furnace, thereby dry etching the surface of the silicon carbide raw material. The residence time of the etching gas in the dry etching furnace may be about 24 hours to about 96 hours.

Next, the etching gas may be removed by a wet scrubber, and the pressure of the inside of the dry etching furnace may be increased to about 600 Torr to about 780 Torr.

The dry etching process may additionally include a heat treatment process and an oxide film removal process.

The dry-etched silicon carbide particles may be heat-treated at about 700 °C to about 1300 °C in an atmosphere containing oxygen in the dry etching furnace. The dry-etched silicon carbide particles may be heat-treated at about 800 °C to about 1200 °C in an atmosphere containing oxygen in the dry etching furnace. The dry-etched silicon carbide particles may be heat-treated at about 900 °C to about 1100 °C in an atmosphere containing oxygen in the dry etching furnace. The heat treatment time may be about 10 minutes to about 2 hours. The heat treatment time may be about 20 minutes to about 1 hour.

By the heat treatment, chlorine remaining on the surface of the dry-etched silicon carbide particles may be removed.

The oxide film removal process may include a wet etching process.

The heat-treated silicon carbide raw material is fed into an etch vessel, and deionized water and hydrofluoric acid are additionally fed into the etch vessel.

Next, the silicon carbide raw material and etchant in the etch vessel may be stirred, and an oxide film on the surface of the silicon carbide raw material may be removed.

The silicon carbide raw material from which the oxide film has been removed is neutralized by deionized water.

The method of manufacturing a silicon carbide powder according to another embodiment may include an operation of cleaning the silicon carbide raw material.

The cleaning process may be carried out using a cleaning solution including at least one or more selected from the group consisting of hydrofluoric acid, distilled water, and ultrapure water.

The cleaning process may include a first cleaning operation, a first hydrofluoric acid treatment operation, a second cleaning operation, a second hydrofluoric acid treatment operation, and a third cleaning operation.

The first cleaning operation may be performed for 1 minute to 300 minutes using distilled water, ultrapure water, or pure water. For example, the first cleaning operation may be performed for about 1 minute to about 250 minutes, about 1 minute to about 200 minutes, about 3 minutes to about 150 minutes, about 10 minutes to about 100 minutes, about 15 minutes to about 80 minutes, about 20 minutes to about 60 minutes, or about 20 minutes to about 40 minutes.

Next, the first hydrofluoric acid treatment operation is an operation of cleaning the silicon carbide raw material using a cleaning solution including hydrofluoric acid. The silicon carbide raw material may be stirred for about 1 minute to about 300 minutes, about 1 minute to about 250 minutes, about 1 minute to about 200 minutes, about 3 minutes to about 150 minutes, about 10 minutes to about 100 minutes, about 15 minutes to about 80 minutes, about 20 minutes to about 60 minutes or about 20 minutes to about 40 minutes in the cleaning solution. Next, the silicon carbide raw material may be precipitated in the cleaning solution. The silicon carbide raw material may be precipitated for about 1 minute to about 300 minutes, about 1 minute to about 250 minutes, about 1 minute to about 200 minutes, about 3 minutes to about 150 minutes, about 10 minutes to about 100 minutes, about 15 minutes to about 80 minutes, about 20 minutes to about 60 minutes, or about 20 minutes to about 40 minutes in the cleaning solution.

The second cleaning operation may be performed for 1 minute to 300 minutes using distilled water, ultrapure water, or pure water. For example, the second cleaning operation may be performed for about 1 minute to about 250 minutes, about 1 minute to about 200 minutes, about 3 minutes to about 150 minutes, about 10 minutes to about 100 minutes, about 15 minutes to about 80 minutes, about 20 minutes to about 60 minutes, or about 20 minutes to about 40 minutes.

Next, the second hydrofluoric acid treatment operation is an operation of cleaning the silicon carbide raw material using a cleaning solution including hydrofluoric acid. The silicon carbide raw material may be stirred for about 1 minute to about 300 minutes, about 1 minute to about 250 minutes, about 1 minute to about 200 minutes, about 3 minutes to about 150 minutes, about 10 minutes to about 100 minutes, about 15 minutes to about 80 minutes, about 20 minutes to about 60 minutes, or about 20 minutes to about 40 minutes in the cleaning solution. Next, the silicon carbide raw material may be precipitated in the cleaning solution. The silicon carbide raw material may be precipitated for about 1 minute to about 300 minutes, about 1 minute to about 250 minutes, about 1 minute to about 200 minutes, about 3 minutes to about 150 minutes, about 10 minutes to about 100 minutes, about 15 minutes to about 80 minutes, about 20 minutes to about 60 minutes, or about 20 minutes to about 40 minutes in the cleaning solution.

The third cleaning operation may be performed for 1 minute to 300 minutes using distilled water, ultrapure water, or pure water. For example, the third cleaning operation may be performed for about 1 minute to about 250 minutes, about 1 minute to about 200 minutes, about 3 minutes to about 150 minutes, about 10 minutes to about 100 minutes, about 15 minutes to about 80 minutes, about 20 minutes to about 60 minutes, or about 20 minutes to about 40 minutes.

A method of manufacturing a silicon carbide powder according to another embodiment includes an operation of physically processing a powdered silicon carbide raw material.

In the operation of physically processing the silicon carbide raw material, the silicon carbide powder that has undergone the crushing process and the pulverization process is physically processed. The operation of physically processing the silicon carbide raw material may be performed after pulverizing the silicon carbide raw material into a powder with an appropriate average particle diameter and before performing the pariticle-size classification process.

The operation of physically processing the silicon carbide raw material may include an operation of applying physical impact to the powdered silicon carbide raw material. In the operation of physically processing the silicon carbide raw material, physical impact applied to the silicon carbide raw material may be weaker than physical impact applied in the crushing process and the pulverization process.

Accordingly, fine particles detachably attached to the powdered silicon carbide raw material may be removed.

The operation of applying physical impact to the silicon carbide raw material may include an operation of sonicating the silicon carbide raw material.

In the sonicating operation, ultrasonic shockwaves may be delivered to the powdered silicon carbide raw material.

The sonicating operation may be performed as follows.

First, the powdered silicon carbide raw material is immersed in water. Here, a volume ratio of the water to the powdered silicon carbide may range from about 1:0.5 to about 1:2.

The amount of water in which the silicon carbide raw material is to be immersed may range from about 100 $\ell$ to about 1000 $\ell$.

Next, ultrasonic waves are applied to the powdered silicon carbide raw material. The ultrasonic waves may have a frequency ranging from about 10 kHz to about 50 kHz. In addition, an output of the ultrasonic waves may have a power ranging from about 1000 W to about 20000 W.

In addition, an application time of the ultrasonic waves may range from about 1 minute to about 20 minutes.

The operation of applying physical impact to the silicon carbide raw material may include an operation of stirring the silicon carbide raw material at a high speed.

The high-speed stirring operation may be performed as follows.

First, the powdered silicon carbide raw material is immersed in water. Here, a volume ratio of the water to the powdered silicon carbide may range from about 1:0.5 to about 1:2.

The amount of water in which the silicon carbide raw material is to be immersed may range from about 100 $\ell$ to about 1000 $\ell$.

Next, the silicon carbide raw material is stirred at high speed. The silicon carbide raw material may be stirred at a flow rate ranging from about 0.5m/s to about 5m/s. The silicon carbide raw material may be stirred at a speed ranging fromf about 30rpm to about 300rpm.

By the physical processing process, appropriate physical impact may be applied to the silicon carbide powder.

Accordingly, fine particles may be separated from the silicon carbide powder. In particular, in the crushing process and the pulverization process, fine cracks may occur in the silicon carbide powder. By the fine cracks, the fine particles that can be separated may occur in the silicon carbide powder.

Here, physical impact such as ultrasonic waves may be applied to the silicon carbide powder, and fine particles generated by the fine cracks or the like may be separated from the silicon carbide powder.

Next, the separated fine particles are removed by a centrifugal separation process and/or a filtering process. That is, a silicon carbide powder from which the fine particles have been separated may be purified by the centrifugal separation process and/or the filtering process.

The operation of physically processing a powdered silicon carbide raw material may be performed during and/or after the wet-etching process.

That is, the sonication process or the high-speed stirring process may be performed in a state in which the silicon carbide raw material is immersed in the etchant. In addition, the wet-etching process may be terminated, and the separated fine particles may be removed by a centrifugal separation process and/or a filtering process.

The operation of physically processing a powdered silicon carbide raw material may be performed during and/or after the washing process.

That is, the silicon carbide raw material may be immersed in the washing liquid, and the sonication process or the high-speed stirring process may be performed.

That is, in a state in which the silicon carbide raw material is immersed in the washing liquid, the sonication process or the high-speed stirring process may be performed. In addition, the washing process may be terminated, and the separated fine particles may be removed by a centrifugal separation process and/or a filtering process.

By the graphite removal process, the iron component removal process, the wet-etching process, the dry etching process, and the washing process, the silicon carbide powder according to one embodiment may have a very high purity (such as described below).

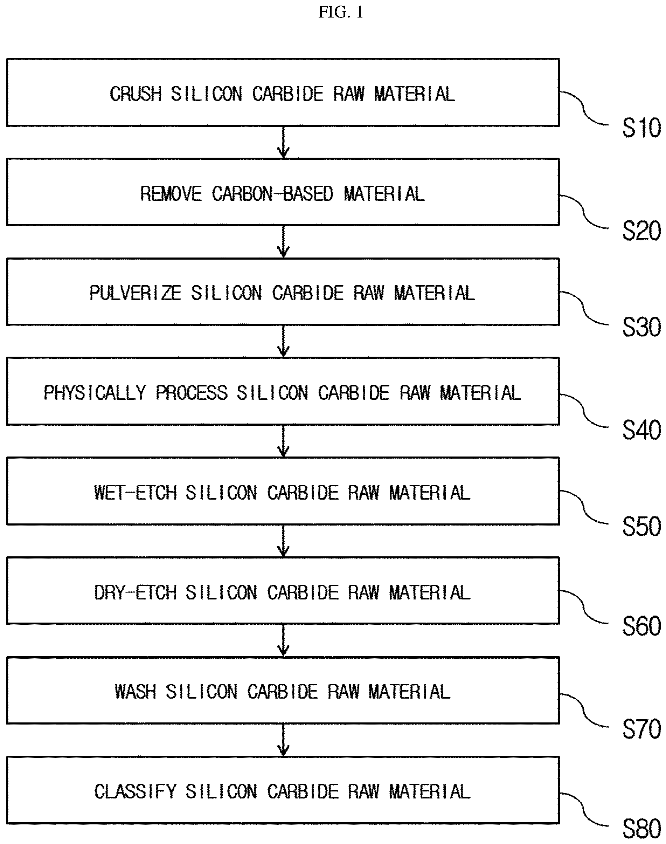

Referring to FIG. 1, a silicon carbide powder according to one embodiment may be prepared by the following process.

First, the silicon carbide raw material is crushed in the crushing process (S10).

Next, a carbon-based material such as graphite included in the silicon carbide raw material is removed by the carbon-based material removal process (S20).

Next, a silicon carbide raw material from which the carbon-based material has been removed is pulverized by the pulverization process (S30).

Next, the pulverized silicon carbide raw material is physically processed (S40). Accordingly, fine particles attached to the pulverized silicon carbide raw material may be removed.

Next, the pulverized silicon carbide raw material is etched by the wet-etching process (S50). Accordingly, impurities attached to the surface of the pulverized silicon carbide raw material may be removed. In particular, a carbon-based material remaining in the pulverized silicon carbide raw material may suspend in the etchant with hydrofluoric acid, etc. contained in the etchant. Accordingly, in the wet-etching process, the carbon-based material as well as metal impurities may be removed.

Next, the wet-etched silicon carbide raw material is etched by a dry etching process (S60).

Next, the dry-etched silicon carbide raw material is subjected to the washing process (S70).

Next, the washed silicon carbide raw material may be classified into a desired particle size (S80).

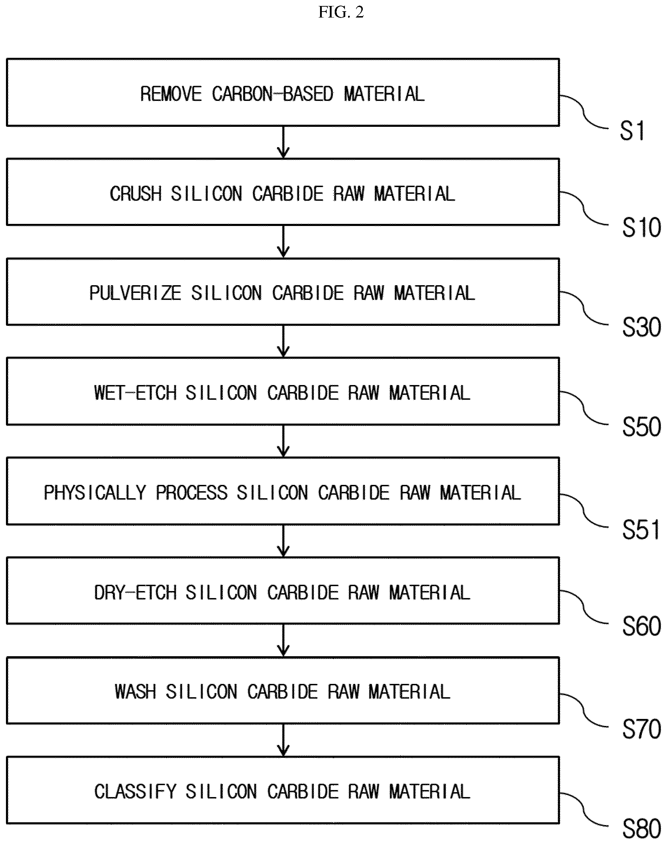

Referring to FIG. 2, the silicon carbide powder according to another embodiment may be prepared by the following process.

In this embodiment, a carbon-based material removal process is substantially the same as the process of FIG. 1, but is be performed before the crushing process (S 1).

When the silicon carbide raw material contains a lot of carbon as impurities, the carbon-based material removal process may precede. For example, when the silicon carbide raw material contains a high percentage of graphite components such as graphite components coated with silicon carbide, the carbon-based material removal process may be performed in advance.

Since the carbon-based material is removed in advance (S1) and is subjected to the crushing process (S10), a carbon-based material contained in the silicon carbide raw material may be more efficiently removed.

Accordingly, the method of manufacturing the silicon carbide powder according to this embodiment may provide a high-purity silicon carbide powder by using a silicon carbide raw material containing a high content of carbon-based material.

In addition, a process (S51) of physically processing a silicon carbide raw material may be performed after a wet-etching process (S50). That is, a sonication or high-speed stirring process may be performed after the silicon carbide raw material is immersed in an etchant and wet-etched, so that fine particles in the silicon carbide raw material may be easily removed.

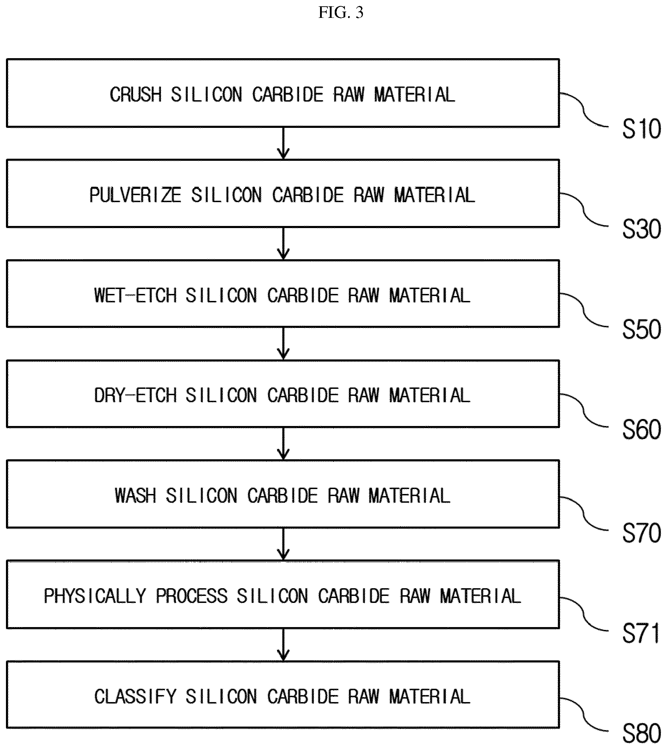

Referring to FIG. 3, the method of manufacturing the silicon carbide powder according to another embodiment may be prepared by the following process.

This embodiment may be substantially the same as the process of FIG. 1, but the carbon-based material removal process may be omitted.

When the silicon carbide raw material does not include a carbon-based material such as the graphite or includes it in a very low content, the carbon-based material removal process may be omitted. For example, the silicon carbide raw material may include about 95 % by weight or more of silicon carbide as in a monocrystalline silicon carbide ingot, a polycrystalline silicon carbide or a silicon carbide sintered body. In this case, a small amount of carbon-based material may be removed in the wet-etching process (S50), etc., so that a high-purity silicon carbide powder may be obtained even without an additional process.

In addition, a process (S71) of physically processing a silicon carbide raw material may be performed after a washing process (S70). That is, since a sonication process or a high-speed stirring process is performed after the silicon carbide raw material is immersed in a washing liquid and a washing process is performed, fine particles in the silicon carbide raw material may be removed.

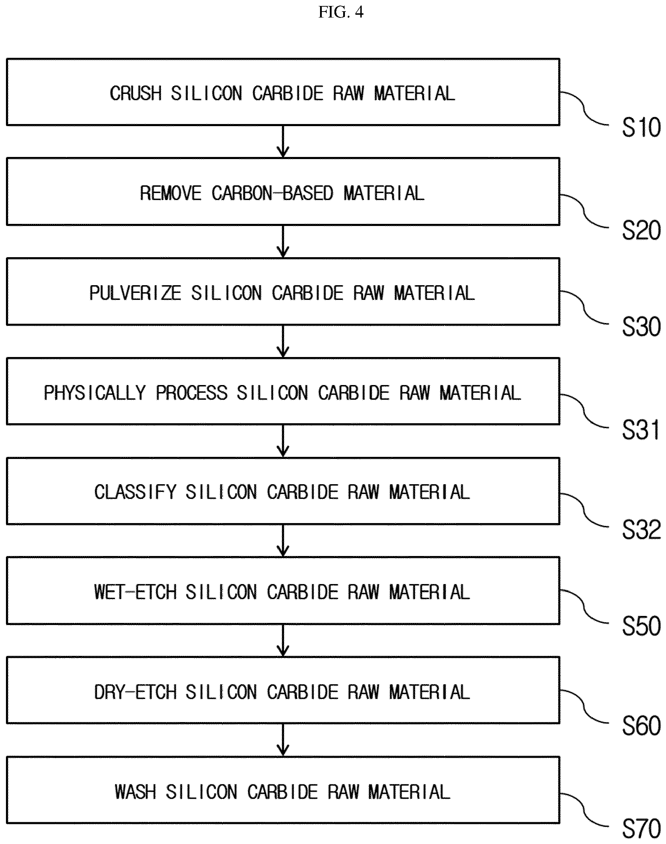

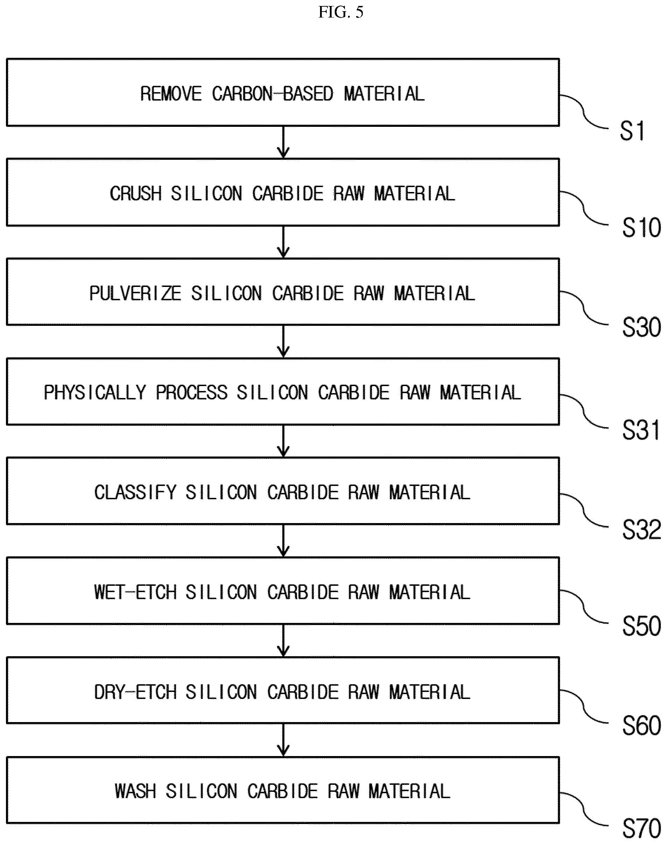

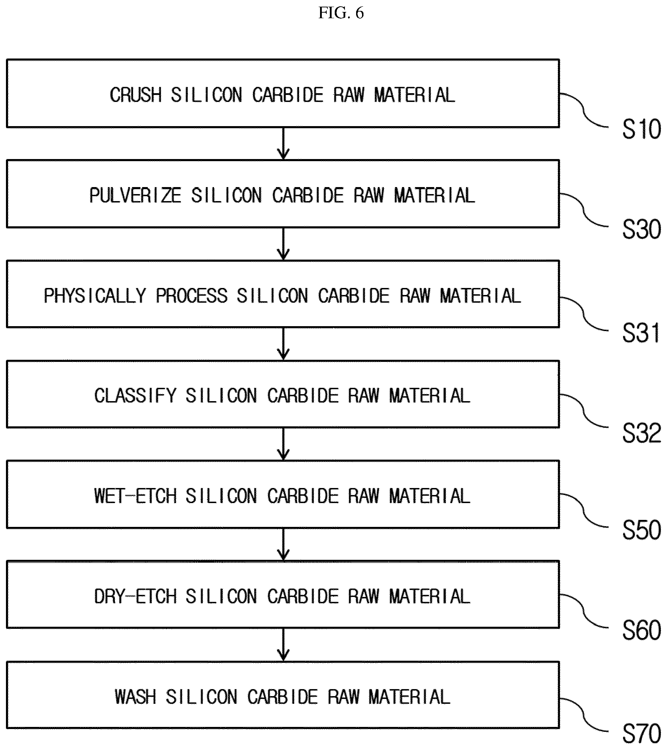

Referring to FIGS. 4 to 6, the silicon carbide powder according to other embodiments may be prepared by the following processes.

These embodiments may be substantially the same as the process of FIG. 1, 2 or 3, but as shown in FIGs. 4, 5, and 6, a process (S31) of physically processing a pulverized silicon carbide powder may be performed after the pulverization process (S30). Futhermore, the classification process (S32) may be performed after the physical processing process (S31). That is, the pulverized silicon carbide raw material may be classified (divided up) into a desired particle size through the classification process immediately after the pulverization process. The classified silicon carbide raw material may be subjected to the wet-etching process, the dry etching process and the washing process.

In the embodiments in FIGs. 4, 5, and 6, since the silicon carbide raw material is classified (by particle size) into a uniform particle size, and then subjected to the wet-etching process and the dry etching process, the surface of the silicon carbide raw material may be uniformly etched as a whole. In particular, since the silicon carbide raw material is classified into a uniform particle size, spaces between particles of the silicon carbide raw material may be uniformly formed. Accordingly, the etching gas may uniformly permeate into the spaces between the silicon carbide raw material, and the dry etching process may uniformly etch the silicon carbide raw materials as a whole.

Accordingly, the method of manufacturing the silicon carbide powder according to this embodiment may uniformly control the contents of carbon, silicon and oxygen included in the surface as a whole.

A purity of the silicon carbide powder obtained by the processes in FIGs. 1-4 according to one embodiment may be about 99.99% or more. The purity of the silicon carbide powder according to another embodiment may be about 99.999% or more. The purity of the silicon carbide powder according to another embodiment may be about 99.9999% or more. The purity of the silicon carbide powder according to another embodiment may be about 99.999999% or more. The purity of the silicon carbide powder according to another embodiment may be about 99.9999999% or more. The purity of the silicon carbide powder according to another embodiment may be about 99.9999999% or more. The purity of the silicon carbide powder according to another embodiment may be about 99.99999999% or more.

The silicon carbide powder obtained by the processes in FIGs. 1-4 according to one embodiment may include one or more impurities selected from the group consisting of lithium, sodium, magnesium, aluminum, potassium, calcium, titanium, vanadium, chromium, manganese, iron, cobalt, nickel, copper, zinc and molybdenum in a content of about 1 ppm or less, about 0.8 ppm or less, about 0.7 ppm or less, or ranging from about 0.1 to about 0.7 ppm or ranging from about 0.1 to about 0.6 ppm.

In addition, a particle diameter (D50) of the silicon carbide powder according to one embodiment may range from about 10 $\mu$m to about 10000 $\mu$m. The particle diameter (D50) of the silicon carbide powder according to another embodiment may range from about 100 $\mu$m to about 6000 $\mu$m. The particle diameter (D50) of the silicon carbide powder according to another embodiment may range from about 60 $\mu$m to about 5000 $\mu$m. The particle diameter (D50) of the silicon carbide powder according to another embodiment may range from about 100 $\mu$m to about 4000 $\mu$m. The particle diameter (D50) of the silicon carbide powder according to another embodiment may range from about 150 $\mu$m to about 400 $\mu$m. The particle diameter (D50) of the silicon carbide powder according to another embodiment may range from about 300 $\mu$m to about 800 $\mu$m. The particle diameter (D50) of the silicon carbide powder according to another embodiment may range from about 500 $\mu$m to about 1000 $\mu$m. The particle diameter (D50) of the silicon carbide powder according to another embodiment may range from about 700 $\mu$m to about 2000 $\mu$m. The particle diameter (D50) of the silicon carbide powder according to anotherembodiment may range from about 1000 $\mu$m to about 3000 $\mu$m.

Carbon and oxygen may be included in an appropriate content ratio on the silicon carbide powder according to another embodiment. Accordingly, when a silicon carbide ingot and a silicon carbide wafer are manufactured using the silicon carbide powder according to this embodiment, the content of the oxygen may be appropriate, so that defects of the silicon carbide ingot and the silicon carbide wafer may be reduced.

In particular, since carbon and oxygen are contained in an appropriate content ratio on the surface of the silicon carbide powder, the oxygen may be easily removed by reacting with the carbon in an initial heat treatment operation. Accordingly, oxygen on the surface of the silicon carbide powder may be removed during the initial heat treatment process, and defects in the growing process of the silicon carbide ingot may be minimized.

In addition, the oxygen reacts with the carbon and is removed as carbon dioxide, etc. In the process of removing the oxygen, the consumption amount of the carbon may be reduced. Accordingly, even after the oxygen is removed together with the carbon, the ratios of the silicon and the carbon may be appropriate throughout the silicon carbide powder. Accordingly, the silicon carbide powder according to the embodiment may minimize defects that may occur due to uneven content of the carbon and the silicon.

In addition, silicon and oxygen are contained in an appropriate content ratio on the surface of the silicon carbide powder according to one embodiment. Accordingly, the silicon carbide powder according to this embodiment may be effectively protected from external impurities. That is, the surface of the silicon carbide powder according to this embodiment may include a protective film containing oxygen and may be effectively protected from the introduction of external chemical impurities.

In addition, the silicon carbide powder according to another embodiment may include a fluorine component as a by-product in the manufacturing process. Here, since the method of manufacturing a silicon carbide powder according to one embodiment includes the wet-etching process, the dry etching process and the washing process, the content of the fluorine component is low. In addition, since the process of manufacturing a silicon carbide ingot according to one embodiment includes an initial heat treatment process for the silicon carbide powder, the fluorine component may be removed. That is, the fluorine component may be vaporized and removed in the initial heat treatment process.

The silicon carbide powder according to another embodiment may be used to manufacture a silicon carbide wafer having very high purity (e,g,, having purity levels similar to the purity levels described above for the silicon carbide powder), and improved performance for the resultant silicon carbide wafer can be obtained.

A particle shape of the silicon carbide powder according to one embodiment may be analyzed through 2D image analysis.

The 2D image analysis may be performed by appropriately sampling the silicon carbide powder. For example, in this embodiment, the silicon carbide powder may be sampled in an amount of about 0.1g to about 10 g at a time and may be prepared for sampling of about 5 times to about 100 times, and the 2D image analysis may be performed for each sampling. Here, measurement values are derived through the 2D image analysis, and the feature of the silicon carbide powder according to this embodiment may be defined as an average value of the measurement values.

The sampled silicon carbide powder is scattered in the background. The background may have a color that is visually distinct from the silicon carbide powder. The scattered silicon carbide particles are respectively spaced apart from each other and are arranged so as not to overlap each other.

The particles contained in the silicon carbide powder according to this embodiment are photographed by an optical microscope, thereby obtaining a 2D image of the particles.

Next, the 2D image of the silicon carbide powder may be analyzed by image analysis software. iSolution series manufactured by Image & Microscope Technology (IMT) and the like are examples of image analysis software that can be used.

When the silicon carbide powder is analyzed by the 2D image analysis, the average area of particles contained in the silicon carbide powder may range from about 50,000 $\mu$m$^2$ to 5,000,000 $\mu$m$^2$. When the silicon carbide powder is analyzed by the 2D image analysis, the average area of particles contained in the silicon carbide powder of the present disclosure may range from about 50,000 $\mu$m$^2$ to 100,000 $\mu$m$^2$. When the silicon carbide powder is analyzed by the 2D image analysis, the average area of particles contained in the silicon carbide powder of the present disclosure may range from about 150,000 $\mu$m$^2$ to 250,000 $\mu$m$^2$. When the silicon carbide powder is analyzed by the 2D image analysis, the average area of particles contained in the silicon carbide powder of the present disclosure may range from about 1,000,000 $\mu$m$^2$ to 2,000,000 $\mu$m$^2$. When the silicon carbide powder is analyzed by the 2D image analysis, the average area of particles contained in the silicon carbide powder of the present disclosure may range from about 2,500,000 $\mu$m$^2$ to 3,500,000 $\mu$m$^2$. When the silicon carbide powder t is analyzed by the 2D image analysis, the average area of particles contained in the silicon carbide powder of the present disclosure may range from about 3,500,000 $\mu$m$^2$ to 5,000,000 $\mu$m$^2$.

When the silicon carbide powder is analyzed by the 2D image analysis, an average circumferential length of particles contained in the silicon carbide powder of the present disclosure may range from about 500 $\mu$m to about 10 mm. When the silicon carbide powder is analyzed by the 2D image analysis, the average circumferential length of particles contained in the silicon carbide powder of the present disclosure may range from about 500 $\mu$m to about 1.5 mm. When the silicon carbide powder is analyzed by the 2D image analysis, the average circumferential length of particles contained in the silicon carbide powder of the present disclosure may range from about 1.5 mm to about 2.5 mm. When the silicon carbide powder is analyzed by the 2D image analysis, the average circumferential length of particles contained in the silicon carbide powder of the present disclosure may range from about 4 mm to about 6 mm. When the silicon carbide powder is analyzed by the 2D image analysis, the average circumferential length of particles contained in the silicon carbide powder of the present disclosure may range from about 7 mm to about 10 mm.

When the silicon carbide powder according to this embdiment is analyzed by the 2D image analysis, a mean equivalent circle diameter of particles contained in the silicon carbide powder of the present disclosure may range from about 150 $\mu$m to about 3 mm. The equivalent circle diameter is calculated based on an area. That is, assuming a circle equal to the area, the equivalent circle diameter may mean the diameter of the circle. When the silicon carbide powder is analyzed by the 2D image analysis, the mean equivalent circle diameter of particles contained in the silicon carbide powder of the present disclosure may range from about 150 $\mu$m to about 300 $\mu$m. When the silicon carbide powder is analyzed by the 2D image analysis, the mean equivalent circle diameter of particles contained in the silicon carbide powder of the present disclosure may range from about 300 $\mu$m to about 700 $\mu$m. When the silicon carbide powder is analyzed by the 2D image analysis, the mean equivalent circle diameter of particles contained in the silicon carbide powder of the present disclosure may range from about 1000 $\mu$m to about 1500 $\mu$m. When the silicon carbide powder is analyzed by the 2D image analysis, the mean equivalent circle diameter of particles contained in the silicon carbide powder of the present disclosure may range from about 1500 $\mu$m to about 2300 $\mu$m. When the silicon carbide powder is analyzed by the 2D image analysis, the mean equivalent circle diameter of particles contained in the silicon carbide powder of the present disclosure may range from about 2000 $\mu$m to about 2500 $\mu$m.

When the silicon carbide powder is analyzed by the 2D image analysis, an average maximum elliptical diameter of particles contained in the silicon carbide powder of the present disclosure may range from about 300 $\mu$m to about 3500 $\mu$m. When the silicon carbide powder is analyzed by the 2D image analysis, the average maximum elliptical diameter of particles contained in the silicon carbide powder of the present disclosure may range from about 300 $\mu$m to about 400 $\mu$m. When the silicon carbide powder is analyzed by the 2D image analysis, the average maximum elliptical diameter of particles contained in the silicon carbide powder of the present disclosure may range from about 600 $\mu$m to about 750 $\mu$m. When the silicon carbide powder is analyzed by the 2D image analysis, the average maximum elliptical diameter of particles contained in the silicon carbide powder of the present disclosure may range from about 1000 $\mu$m to about 2000 $\mu$m. When the silicon carbide powder is analyzed by the 2D image analysis, the average maximum elliptical diameter of particles contained in the silicon carbide powder of the present disclosure may range from about 2500 $\mu$m to about 3500 $\mu$m. When the silicon carbide powder is analyzed by the 2D image analysis, the average maximum elliptical diameter of particles contained in the silicon carbide powder of the present disclosure may range from about 550 $\mu$m to about 800 $\mu$m.

When the silicon carbide powder is analyzed by the 2D image analysis, an average minimum elliptical diameter of particles contained in the silicon carbide powder of the present disclosure may range from about 150 $\mu$m to about 2500 $\mu$m. When the silicon carbide powder is analyzed by the 2D image analysis, the average minimum elliptical diameter of particles contained in the silicon carbide powder of the present disclosure may range from about 150 $\mu$m to about 250 $\mu$m. When the silicon carbide powder is analyzed by the 2D image analysis, the average minimum elliptical diameter of particles contained in the silicon carbide powder of the present disclosure may range from about 300 $\mu$m to about 500 $\mu$m. When the silicon carbide powder is analyzed by the 2D image analysis, the average minimum elliptical diameter of particles contained in the silicon carbide powder of the present disclosure may range from about 850 $\mu$m to about 1300 $\mu$m. When the silicon carbide powder is analyzed by the 2D image analysis, the average minimum elliptical diameter of particles contained in the silicon carbide powder of the present disclosure may range from about 1300 $\mu$m to about 1900 $\mu$m. When the silicon carbide powder is analyzed by the 2D image analysis, the average minimum elliptical diameter of particles contained in the silicon carbide powder of the present disclosure may range from about 1700 $\mu$m to about 2500 $\mu$m.

When the silicon carbide powder is analyzed by the 2D image analysis, an average maximum length of particles contained in the silicon carbide powder of the present disclosure may range from about 250 $\mu$m to about 3000 $\mu$m. Here, the maximum length may mean a length in the longest direction in a 2D image of each particle. When the silicon carbide powder is analyzed by the 2D image analysis, the average maximum length of particles contained in the silicon carbide powder of the present disclosure may range from about 250 $\mu$m to about 400 $\mu$m. When the silicon carbide powder of the present disclosure is analyzed by the 2D image analysis, the average maximum length of particles contained in the silicon carbide powder may range from about 500 $\mu$m to about 800 $\mu$m. When the silicon carbide powder is analyzed by the 2D image analysis, the average maximum length of particles contained in the silicon carbide powder of the present disclosure may range from about 1300 $\mu$m to about 1800 $\mu$m. When the silicon carbide powder is analyzed by the 2D image analysis, the average maximum length of particles contained in the silicon carbide powder of the present disclosure may range from about 1700 $\mu$m to about 2300 $\mu$m. When the silicon carbide powder is analyzed by the 2D image analysis, the average maximum length of particles contained in the silicon carbide powder of the present disclosure may range from about 2200 $\mu$m to about 3000 $\mu$m.

When the silicon carbide powder is analyzed by the 2D image analysis, an average maximum frame diameter of the particles contained in the silicon carbide powder may range from about 300 $\mu$m to about 3500 $\mu$m. The image of the captured particles may be measured with a virtual vernier caliper while rotating. Here, the maximum frame diameter may mean the largest width of the measured widths. When the silicon carbide powder is analyzed by the 2D image analysis, the average maximum frame diameter of the particles contained in the silicon carbide powder of the present disclosure may range from about 300 $\mu$m to about 450 $\mu$m. When the silicon carbide powder is analyzed by the 2D image analysis, the average maximum frame diameter of the particles contained in the silicon carbide powder of the present disclosure may range from about 500 $\mu$m to about 900 $\mu$m. When the silicon carbide powder is analyzed by the 2D image analysis, the average maximum frame diameter of the particles contained in the silicon carbide powder of the present disclosure may range from about 1300 $\mu$m to about 2000 $\mu$m. When the silicon carbide powder is analyzed by the 2D image analysis, the average maximum frame diameter of the particles contained in the silicon carbide powder of the present disclosure may range from about 2200 μm to about 2600 μm. When the silicon carbide powder is analyzed by the 2D image analysis, the average maximum frame diameter of the particles contained in the silicon carbide powder of the present disclosure may range from about 2700 μm to about 3500 μm.

When the silicon carbide powder is analyzed by the 2D image analysis, an average minimum frame diameter of the particles contained in the silicon carbide powder of the present disclosure may range from about 150 μm to about 2200 μm. The image of the captured particles may be measured with a virtual vernier caliper while rotating. Here, the minimum frame diameter may mean the smallest width of the measured widths. When the silicon carbide powder is analyzed by the 2D image analysis, the average minimum frame diameter of the particles contained in the silicon carbide powder of the present disclosure may range from about 150 μm to about 280 μm. When the silicon carbide powder is analyzed by the 2D image analysis, the average minimum frame diameter of the particles contained in the silicon carbide powder of the present disclosure may range from about 350 μm to about 450 μm. When the silicon carbide powder is analyzed by the 2D image analysis, the average minimum frame diameter of the particles contained in the silicon carbide powder of the present disclosure may range from about 750 μm to about 1250 μm. When the silicon carbide powder is analyzed by the 2D image analysis, the average minimum frame diameter of the particles contained in the silicon carbide powder of the present disclosure may range from about 1300 μm to about 1800 μm. When the silicon carbide powder is analyzed by the 2D image analysis, the average minimum frame diameter of the particles contained in the silicon carbide powder of the present disclosure may range from about 1800 μm to about 2200 μm.

When the silicon carbide powder is analyzed by the 2D image analysis, the average minimum frame diameter of the particles contained in the silicon carbide powder of the present disclosure may range from about 250 μm to about 2700 μm. The image of the captured particles may be measured with a virtual vernier caliper while rotating. Here, the middle frame diameter may mean the average of measured widths. When the silicon carbide powder is analyzed by the 2D image analysis, the average minimum frame diameter of the particles contained in the silicon carbide powder of the present disclosure may range from about 250 μm to about 350 μm. When the silicon carbide powder is analyzed by the 2D image analysis, the average minimum frame diameter of the particles contained in the silicon carbide powder of the present disclosure may range from about 400 μm to about 600 μm. When the silicon carbide powder is analyzed by the 2D image analysis, the average minimum frame diameter of the particles contained in the silicon carbide powder of the present disclosure may range from about 1250 μm to about 1700 μm. When the silicon carbide powder is analyzed by the 2D image analysis, the average minimum frame diameter of the particles contained in the silicon carbide powder of the present disclosure may range from about 1800 μm to about 2200 μm. When the silicon carbide powder is analyzed by the 2D image analysis, the average minimum frame diameter of the particles contained in the silicon carbide powder of the present disclosure may range from about 2300 μm to about 2700 μm.

When the silicon carbide powder is analyzed by the 2D image analysis, an average convex hull of the particles contained in the silicon carbide powder of the present disclosure may range from about 700 μm to about 10000 μm. When the silicon carbide powder is analyzed by the 2D image analysis, the average convex hull of the particles contained in the silicon carbide powder of the present disclosure may range from about 700 μm to about 1300 μm. When the silicon carbide powder is analyzed by the 2D image analysis, the average convex hull of the particles contained in the silicon carbide powder of the present disclosure may range from about 1600 μm to about 2200 μm. When the silicon carbide powder is analyzed by the 2D image analysis, the average convex hull of the particles contained in the silicon carbide powder of the present disclosure may range from about 4000 μm to about 5000 μm. When the silicon carbide powder is analyzed by the 2D image analysis, the average convex hull of the particles contained in the silicon carbide powder of the present disclosure may range from about 6000 μm to about 7000 μm. When the silicon carbide powder is analyzed by the 2D image analysis, the average convex hull of the particles contained in the silicon carbide powder of the present disclosure may range from about 7000 μm to about 9000 μm.

When the silicon carbide powder is analyzed by the 2D image analysis, an average particle circularity of the particles contained in the silicon carbide powder of the present disclosure may range from 0.4 to 0.9. When the silicon carbide powder is analyzed by the 2D image analysis, the average particle circularity of the particles contained in the silicon carbide powder of the present disclosure may range from 0.4 to 0.8. When the silicon carbide powder is analyzed by the 2D image analysis, the average particle circularity of the particles contained in the silicon carbide powder of the present disclosure may range from 0.45 to 0.75. When the silicon carbide powder is analyzed by the 2D image analysis, the average particle circularity of the particles contained in the silicon carbide powder of the present disclosure may range from 0.5 to 0.7. When the silicon carbide powder is analyzed by the 2D image analysis, the average particle circularity of the particles contained in the silicon carbide powder of the present disclosure may range from 0.55 to 0.7.

The particle circularity may be calculated according to the following equation:

Equation 1

$$\text{Particle circularity} = 4 \times \pi \times \text{particle area} / (\text{circumference})^2$$

When the silicon carbide powder is analyzed by the 2D image analysis, an average particle ellipticity of the particles contained in the silicon carbide powder of the present disclosure may range from 0.85 to 1. When the silicon carbide powder is analyzed by the 2D image analysis, the average particle ellipticity of the particles contained in the silicon carbide powder of the present disclosure may range from 0.90 to 1. When the silicon carbide powder is analyzed by the 2D image analysis, the average particle ellipticity of the particles contained in the silicon carbide powder of the present disclosure may range from 0.91 to 1. When the silicon carbide powder is analyzed by the 2D image analysis, the average particle ellipticity of the particles contained in the silicon carbide powder of the present disclosure may range from 0.93 to 1. In one embodiment, a particle ellipticity measured through the 2D image analysis may be 0.92 or more.

When the silicon carbide powder is analyzed by the 2D image analysis, an average particle convexity of the particles contained in the silicon carbide powder of the present disclosure may range from about 0.83 to about 0.99.

The particle convexity may be calculated by Equation 2 below:

$$\text{Equation 2}$$

$$\text{Particle convexity} = \text{Convex hull} / \text{circumference}$$

When the silicon carbide powder is analyzed by the 2D image analysis, the average particle convexity of the particles contained in the silicon carbide powder of the present disclosure may range from about 0.83 to about 0.99. When the silicon carbide powder is analyzed by the 2D image analysis, the average particle convexity of the particles contained in the silicon carbide powder of the present disclosure may range from about 0.84 to about 0.98. When the silicon carbide powder is analyzed by the 2D image analysis, the average particle convexity of the particles contained in the silicon carbide powder of the present disclosure may range from about 0.85 to about 0.95. When the silicon carbide powder is analyzed by the 2D image analysis, the average particle convexity of the particles contained in the silicon carbide powder of the present disclosure may range from about 0.86 to about 0.94. In one embodiment, a particle convexity measured through the 2D image analysis may be 0.9 to 0.99.

When the silicon carbide powder is analyzed by the 2D image analysis, an average particle elongation of the particles contained in the silicon carbide powder of the present disclosure may range from about 0.8 to about 0.95.

The particle elongation may be calculated by Equation 3 below:

$$\text{Equation 3}$$

$$\text{Particle elongation} = \text{Equivalent circle diameter} / \text{maximum length}$$

As the particle elongation approaches 1, the 2D image of the particles shows a converging shape, and as the particle elongation approaches 0, the 2D image of the particles shows an elongated shape.

When the silicon carbide powder is analyzed by the 2D image analysis, the average particle elongation of the particles contained in the silicon carbide powder of the present disclosure may range from about 0.81 to about 0.95. When the silicon carbide powder is analyzed by the 2D image analysis, the average particle elongation of the particles contained in the silicon carbide powder of the present disclosure may range from about 0.82 to about 0.94. When the silicon carbide powder is analyzed by the 2D image analysis, the average particle elongation of the particles contained in the silicon carbide powder of the present disclosure may range from about 0.83 to about 0.93.

When the silicon carbide powder is analyzed by the 2D image analysis, an average charging space elongation of the particles contained in the silicon carbide powder of the present disclosure may range from 0.65 to 0.85.

The silicon carbide powder of the present disclosure according to one embodiment may have a repose angle.

The repose angle of the silicon carbide powder may be about 20° to about 45°. The repose angle of the silicon carbide powder according to one embodiment may be about 25° to about 45°. The repose angle of the silicon carbide powder according to another embodiment may be about 25° to about 40°.

The repose angle may be measured by the following method:

The silicon carbide powder is poured into a circular plate having a diameter of about 100 mm, and the silicon carbide powder according to this embodiment is deposited in a conical shape to form a deposited layer. The repose angle may be an angle between the horizontal plane and the slope of the sedimentary layer.

The silicon carbide powder of the present disclosure according to one embodiment may have a tap density.

The tap density of the silicon carbide powder according to one embodiment may ramge from about 1.3g/cm$^3$ to about 2.5g/cm3. The tap density of the silicon carbide powder according to one embodiment may ramge from about 1.5g/cm3 to about 2.0 g/cm3. The tap density of the silicon carbide powder according to the embodiment may be about 1.5g/cm3 to about 1.8g/cm3.

The tap density may be measured by the following method.

The tap density may be measured using a tap density measurement instrument.

In this method, about 100 g of silicon carbide powder is filled into a 250 ml cylinder. Next, the cylinder is tapped until the volume of the silicon carbide powder is reduced by about 2%. Here, the apparent density of the silicon carbide powder (its mass/thevolume after tapping) is the tap density.

In the silicon carbide powder according to one embodiment, a mass ratio of particles having a particle diameter of less than 50 μm may be less than 10 wt%. A mass ratio (WR50) of particles having a particle diameter of less than 50 μm may be calculated according to Equation 4 below:

Equation 4

$$WR50 = (\text{Mass of silicon carbide particles having particle diameter of less than 50 } \mu m)/$$

$$(\text{mass of total silicon carbide particles})$$

With the silicon carbide powder according to this embodiment, the mass ratio of particles having a particle diameter of less than 50 μm may be less than 9 wt%. The mass ratio of particles having a particle diameter of less than 50 μm may be less than 8 wt%. The mass ratio of particles having a particle diameter of less than 50 μm may be less than 7 wt%. The mass ratio of particles having a particle diameter of less than 50 μm may be less than 6 wt%. The mass ratio of particles having a particle diameter of less than 50 μm may be less than 5 wt%. A minimum value of the mass ratio of particles having a particle diameter of less than 50 μm may be 0.01 wt%.

In the silicon carbide powder according to anotherembodiment, a mass ratio of particles having a particle diameter of less than 10 μm may be less than 3 wt%. The mass ratio (WR10) of particles having a particle diameter of less than 10 μm may be calculated by Equation 5 below:

Equation 5

$$WR10 = (\text{Mass of silicon carbide particles having particle diameter of less than 10 } \mu m)/$$

$$(\text{mass of total silicon carbide particles})$$

With the silicon carbide powder according to this embodiment, the mass ratio of particles having a particle diameter of less than 10 μm may be less than 3 wt%. The mass ratio of particles having a particle diameter of less than 10 μm may be less than 2.5 wt%. The mass ratio of particles having a particle diameter of less than 10 μm may be less than 2 wt%. The mass ratio of particles having a particle diameter of less than 10 μm may be less than 1.5 wt%. The mass ratio of particles having a particle diameter of less than 10 μm may be less than 1 wt%. A minimum value of the mass ratio of particles having a particle diameter of less than 10 μm may be 0.005 wt%.

In the silicon carbide powder according to another embodiment, the mass ratio of particles having a particle diameter of less than 5 μm may be less than 2 wt%. The mass ratio of particles having a particle diameter of less than 5 μm (WR5) may be calculated by Equation 6 below:

Equation 6

$$WR50 = (\text{Mass of silicon carbide particles having particle diameter of less than 5 } \mu m)/$$

$$(\text{mass of total silicon carbide particles})$$

With the silicon carbide powder according to this embodiment, the mass ratio of particles having a particle diameter of less than 5 μm may be less than 2 wt%. The mass ratio of particles having a particle diameter of less than 5 μm may be less than 1.5 wt%. The mass ratio of particles having a particle diameter of less than 5 μm may be less than 1 wt%. A minimum value of the mass ratio of particles having a particle diameter of less than 5 μm may be less than 0.001 wt%.

In the silicon carbide powder according to another embodiment, a mass ratio of particles having a particle diameter of less than 50 μm after the sonication may be less than 10 Wt%. The mass ratio (SWR50) of particles having a particle diameter of less than 5 μm after the sonication may be calculated by Equation 7 below:

Equation 7

$$\text{SWR5} = \text{(Mass of silicon carbide particles having particle diameter of less than 50 μm after sonication)/ (mass of total silicon carbide particles)}$$

With the silicon carbide powder according to this embodiment, the mass ratio of particles having a particle diameter of less than 50 μm after the sonication may be less than 9 wt%. The mass ratio of particles having a particle diameter of less than 50 μm after the sonication may be less than 8 wt%. The mass ratio of particles having a particle diameter of less than 50 μm after the sonication may be less than 7 wt%. The mass ratio of particles having a particle diameter of less than 50 μm after the sonication may be less than 6 wt%. The mass ratio of particles having a particle diameter of less than 50 μm after the sonication may be less than 5 wt%. A minimum value of the mass ratio of particles having a particle diameter of less than 50 μm after the sonication may be 0.01 wt%.

In the silicon carbide powder according to another embodiment, the mass ratio of particles having a particle diameter of less than 10 μm after the sonication may be less than 3 wt%. The mass ratio (SWR10) of particles having a particle diameter of less than 10 μm after the sonication may be calculated by Equation 8 below:

Equation 8

$$\text{SWR10} = \text{(Mass of silicon carbide particles having particle diameter of less than 10 μm after sonication) / (mass of total silicon carbide particles)}$$

With the silicon carbide powder according to this embodiment, the mass ratio of particles having a particle diameter of less than 10 μm after the sonication may be less than 3 wt%. The mass ratio of particles having a particle diameter of less than 10 μm after the sonication may be less than 2.5 wt%. The mass ratio of particles having a particle diameter of less than 10 μm after the sonication may be less than 2 wt%. The mass ratio of particles having a particle diameter of less than 10 μm after the sonication may be less than 1.5 wt%. The mass ratio of particles having a particle diameter of less than 10 μm after the sonication may be less than 1 wt%. A minimum value of the mass ratio of particles having a particle diameter of less than 10 μm after the sonication may be 0.005 wt%.

In the silicon carbide powder according to another embodiment, the mass ratio of particles having a particle diameter of less than 5 μm after the sonication may be less than 2 wt%. The mass ratio (SWR5) of particles having a particle diameter of less than 5 μm after the sonication may be calculated by Equation 9 below:

Equation 9

$$\text{SWR5} = \text{(Mass of silicon carbide particles having particle diameter of less than 5 μm after sonication) / (mass of total silicon carbide particles)}$$

With the silicon carbide powder according to this embodiment, the mass ratio of particles having a particle diameter of less than 5 μm after the sonication may be less than 2 wt%. The mass ratio of particles having a particle diameter of less than 5 μm after the sonication may be less than 1.5 wt%. The mass ratio of particles having a particle diameter of less than 5 μm after the sonication may be less than 1 wt%. A minimum value of the mass ratio of particles having a particle diameter of less than 5 μm after the sonication may be 0.001 wt%.

In addition, in the silicon carbide powder according to another embodiment, a difference between a mass ratio of particles with a particle diameter of less than 50 μm before sonication and the mass ratio after sonication is less than about 1 wt%. In the silicon carbide powder according to another embodiment, a difference between a mass ratio of particles with a particle diameter of less than 50 μm before sonication and the mass ratio after sonication may be less than about 0.5 wt%. In the silicon carbide powder according to another embodiment, a difference between a mass ratio of particles with a particle diameter of less than 50 μm before sonication and the mass ratio after sonication may be less than about 0.4 wt%. In the silicon carbide powder according to another embodiment, a difference between a mass ratio of particles with a particle diameter of less than 50 μm before sonication and the mass ratio after sonication may be less than about 0.3 wt%. The difference between a mass ratio of particles with a particle diameter of less than 50 μm before sonication and the mass ratio after sonication may be calculated by Equation 10 below:

Equation 10

$$\triangle WR50 = \left| WR50\text{-}SWR50 \right|$$

In addition, in the silicon carbide powder according to another embodiment, a difference between a mass ratio of particles with a particle diameter of less than 10 μm before sonication and the mass ratio after sonication is less than about 0.5 wt%. In the silicon carbide powder according to another embodiment, a difference between a mass ratio of particles with a particle diameter of less than 10 μm before sonication and the mass ratio after sonication may be less than about 0.3 wt%. In the silicon carbide powder according to another embodiment, a difference between a mass ratio of particles with a particle diameter of less than 10 μm before sonication and the mass ratio after sonication may be less than about 0.2 wt%. In the silicon carbide powder according to another embodiment, a difference between a mass ratio of particles with a particle diameter of less than 10 μm before sonication and the mass ratio after sonication may be less than about 0.1 wt%. The difference between a mass ratio of particles with a particle diameter of less than 10 μm before sonication and the mass ratio after sonication may be calculated by Equation 11 below:

Equation 11

$$\triangle WR10 = \left| WR10\text{-}SWR10 \right|$$

In addition, in the silicon carbide powder according to another embodiment, a difference between a mass ratio of particles with a particle diameter of less than 5 μm before sonication and the mass ratio after sonication is less than 0.3 wt%. In the silicon carbide powder according to another embodiment, a difference between a mass ratio of particles with a particle diameter of less than 5 μm before sonication and the mass ratio after sonication may be less than 0.2 wt%. In the silicon carbide powder according to another embodiment, a difference between a mass ratio of particles with a particle diameter of less than 5 μm before sonication and the mass ratio after sonication may be less than 0.1 wt%. In the silicon carbide powder according to another embodiment, a difference between a mass ratio of particles with a particle diameter of less than 5 μm before sonication and the mass ratio after sonication may be less than 0.05 wt%. The difference between a mass ratio of particles with a particle diameter of less than 5 μm before sonication and the mass ratio after sonication may be calculated by Equation 12 below:

Equation 12

$$\triangle WR5 = \left| WR5\text{-}SWR5 \right|$$

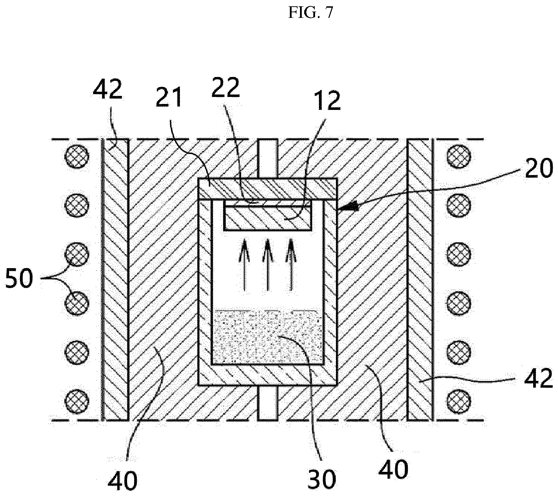

The sonication may be performed as follows:
The silicon carbide powder was added to about 10 ℓ of deionized water in a volume ratio of about 1:1. Next, ultrasonic waves having a frequency of about 40 kHz and an output of about 1200 W were applied to the silicon carbide powder for about 5 minutes.
The particle diameter of the silicon carbide particles may be measured by the following method.
The silicon carbide powder according to this embodiment was classified by a 100 μm mesh, particles that passed through the mesh were dispersed in ultrapure water, and the particle diameter and the content were measured by a particle size meter (Mastersizer 3000, manufactured by Malvern). Accordingly, particle diameter-depended contents were derived.
Referring to FIG. 7, a silicon carbide wafer according to an embodiment can be manufactured as follows.
First, a silicon carbide ingot can be manufactured. The silicon carbide ingot is manufactured by applying the physical vapor transport (PVT) method to have a large area and few defects.

A method of manufacturing a silicon carbide ingot 12 according to one embodiment may include a preparation operation, a silicon carbide powder-loading operation and a growth operation.

The preparation operation is an operation of preparing a crucible assembly including a crucible body 20 having an inner space and a crucible cover 21 for covering the crucible body.

The silicon carbide powder-loading operation is an operation of loading a silicon carbide powder 30 in the crucible assembly and placing a seed tablet displaced from the silicon carbide raw material at a certain distance from the silicon carbide raw material.

The crucible body 20 may have, for example, a cylindrical shape having an open upper surface and a structure in which a silicon carbide raw material can be loaded. The crucible body 20 may have a density of 1.70 g/cm3 to 1.90 g/cm3. A material of the crucible body 20 may include graphite.

The crucible cover 21 may be a density of 1.70 g/cm3 to 1.90 g/cm3. The material of the crucible cover 21 may include graphite. The crucible cover 21 may cover the entire opening of the crucible body 20.

The crucible cover 21 may cover a portion of the opening of the crucible body 20 or include a through hole. the rate of vapor transfer in a crystal growth atmosphere to be described later can be adjusted.

In addition, a seed tablet holder 22 is disposed on the crucible cover 21. The seed tablet holder 22 may be coupled to the crucible cover 21. The seed tablet holder 22 may be attached to the crucible cover 21. The seed tablet holder 22 may be integrally formed with the crucible cover 21.

The thickness of the crucible cover 21 may be about 10 mm to about 50 mm. In addition, the thickness of the seed tablet holder 22 may be about 1 mm to about 10 mm.

To manufacture the silicon carbide ingot, a seed tablet was prepared. The seed tablet may be any one of silicon carbide wafers to which an off angle, which is an angle selected from a range of 0 to 8 degrees with respect to the (0001) plane, is applied.

The seed tablet may be a 4H-SiC ingot that is a substantially single crystal with minimal defects or polymorphic inclusions. The silicon carbide seed tablet may be substantially made of 4H-SiC.

The seed tablet may have a diamenter of 4 inches or more, 5 inches or more, even 6 inches or more. More specifically, the seed tablet may have a diameter of 4 to 12 inches, 4 to 10 inches, or 6 to 8 inches.

The seed tablet is attached to a seed tablet holder. The seed tablet holder contains graphite. The seed tablet holder may be made of graphite. The seed tablet holder may include anisotropic graphite. In more detail, the seed tablet holder may be formed of anisotropic graphite.

In addition, the seed tablet and the seed tablet holder are adhered to each other by an adhesive layer. The adhesive layer includes a graphite filler and a carbide such as a phenolic resin. The adhesive layer may have a low porosity.

The C surface (0001) side of the silicon carbide seed tablet may be placed facing downward.

Next, the silicon carbide powder according to one embodiment was loaded to manufacture the silicon carbide ingot in the crucible.

A silicon carbide powder 30 includes a carbon source and a silicon source. Specifically, the silicon carbide powder 30 includes a carbon-silicon source. The silicon carbide powder 30 may have the characteristics described above.

When the silicon carbide powder 30 is loaded in the crucible, the bulk density of the silicon carbide powder 30 may range from about 1400 kg/m$^3$ to about 1700 kg/m$^3$. When the silicon carbide powder 30 is loaded in the crucible, the bulk density of the silicon carbide powder 30 may range from about 1500 kg/m$^3$ to about 1650 kg/m$^3$.

The silicon carbide powder 30 having a particle size of 75 um or less may be included in an amount of 15 % by weight or less, 10 % by weight or less, or 5 % by weight or less based on the total raw material. When a raw material includes small particles in a relatively small content, a silicon carbide ingot that can reduce the occurrence of defects in an ingot, is more advantageous in controlling supersaturation, and a wafer with improved crystal characteristics can be manufactured.

The silicon carbide powder 30 may be necked or non-necked to each other. When a raw material having the particle diameter is applied, a silicon carbide ingot that can provide a wafer with better crystal characteristics can be manufactured.

In the silicon carbide powder-loading operation, the crucible assembly may have a weight ratio (Rw) that is 1.5 to 2.7 times the weight of the silicon carbide powder 3 when the weight of the silicon carbide powder 30 is 1. Here, the weight of the crucible assembly means the weight of the crucible assembly excluding the raw material. Specifically, the weight of the crucible assembly is a value obtained by excluding the weight of an added raw material from the weight of the crucible assembly including a seed tablet, regardless of whether a seed holder is applied to the crucible assembly.

If the weight ratio is less than 1.5, supersaturation increases excessively in the crystal growth atmosphere, so that the crystal quality of the ingot may rather deteriorate. If the weight ratio exceeds 2.7, supersaturation decreases so that the crystal quality of the ingot may deteriorate.

The weight ratio may range from 1.6 to 2.6 or 1.7 to 2.4. Within these weight ratios, an ingot with excellent defect characteristics and crystallinity characteristics can be manufactured.

When the diameter of the inner space of the crucible body 20 is 1, the length ratio, which is a ratio of the length from the bottom surface, where the silicon carbide powder 30 is located, of the crucible assembly to the surface of a seed tablet 11, may be greater than 1 times and less than 25 times.

The growth operation is an operation in which the inner space of the crucible body 20 is adjusted to a crystal growth atmosphere to vapor-transfer and deposit the raw material to the seed tablet and prepare a silicon carbide ingot grown from the seed tablet.

The growth operation may include an operation of adjusting the inner space of the crucible assembly to a crystal growth atmosphere. Specifically, a reaction vessel containing the crucible assembly and the insulator surrounding the crucible assembly may be prepared by wrapping the crucible assembly with an insulator 40, and the crucible, etc. may be heated using a heating means after placing the reaction vessel in a reaction chamber 42 such as a quartz tube.

The reaction vessel was placed in a reaction chamber 42, and the inner space of the crucible body 20 was brought to a temperature suitable for a crystal growth atmosphere using a heating means 50. This temperature is one of the important factors for the crystal growth atmosphere and forms a more suitable crystal growth atmosphere by adjusting conditions such as pressure and gas movement. The insulator 40 may be located between the reaction chamber 42 and the reaction vessel to facilitate the formation and control of the crystal growth atmosphere.

The insulator 40 may affect the temperature gradient inside the crucible body or the reaction vessel in a growing atmosphere. Specifically, the insulator may include a graphite insulator. More specifically, the insulator may include a rayon-based graphite felt or a pitch-based graphite felt.

In one embodiment, the insulator may have a density of about 0.12 g/cc to about 0.30 g/cc. In another embodiment, the insulator may have a density of about 0.13 g/cc to about 0.25 g/cc. In another embodiment, the insulator may have a density of about 0.14 g/cc to about 0.20 g/cc.

When the density of the insulator is less than about 0.14 g/cc, an ingot may grow in a concave shape, and 6H-SiC polymorphism may occur, thereby deteriorating the quality of the ingot.

When the density of the insulator exceeds about 0.30 g/cc, an ingot may grow excessively convex, and the growth rate of the edges thereof may decrease, which may decrease the yield or increase the occurrence of cracks in the ingot.

When an insulator having a density ranging from about 0.12 g/cc to about 0.30 g/cc is applied, the quality of the ingot may be improved. When an insulator having a density ranging from about 0.14 g/cc to about 0.20 g/cc is applied, a crystal growth atmosphere can be controlled in an ingot growth process and an ingot of better quality can be grown.

The insulator may have a porosity ranging from about 73 vol% to about 95 vol%. The insulator may have a porosity ranging from about 76 vol% to about 93 vol%%. The insulator may have a porosity ranging from 81 vol% to 91 vol%. When an insulator having such a porosity is applied, the frequency of cracks in the ingot may be further reduced.

The insulator may have a compressive strength of about 0.21 Mpa or more. The insulator may have a compressive strength of about 0.49 Mpa or more. The insulator may have a compressive strength of about 0.78 MPa or more. In addition, the insulator may have a compressive strength of about 3 MPa or less or a compressive strength of about 25 MPa or less. When the insulator has such a compressive strength, excellent thermal/mechanical stability is exhibited, and iSiC ingots of better quality can be manufactured because the probability of ash is reduced.

The insulator may be applied to a thickness of about 20 mm or more or a thickness of about 30 mm or more. In addition, the insulator may be applied to a thickness of about 150 mm or less, a thickness of about 120 mm or less, or a thickness of about 80 mm or less. When the thickness of the insulator is limited to the ranges, sufficient insulation effect can be obtained without unnecessary waste of an insulator.

The insulator 40 may have a density ranging from about 0.12 g/cc to about 0.30 g/cc. The insulator 40 may have a porosity ranging from about 72 vol% to about 90 vol%. When such an insulator is applied, it is possible to suppress the shape of an ingot from growing concave or excessively convex, and it is possible to reduce the deterioration of polymorphic quality or the occurrence of cracks in the ingot.

The crystal growth atmosphere may be implemented by heating the heating device 50 (e.g. an induction coil) outside the reaction chamber 42, the air may be removed by reducing the pressure simultaneously with or separately from the heating, and a reduced pressure atmosphere and/or an inert atmosphere (e.g., Ar atmosphere, N2 atmosphere or a mixture thereof) may be implemented.

The crystal growth atmosphere induces the growth of a silicon carbide crystal by allowing a raw material to vapor-transfer on the surface of a seed tablet to grow into the ingot 100.

The crystal growth atmosphere may be implemented under conditions such as a growth temperature of 2100 °C to 2450 °C and a growth pressure of 1 Torr to 100 Torr. When such a temperature and pressure are applied, a silicon carbide ingot may be more efficiently manufactured.

Specifically, in the crystal growth atmosphere, the upper and lower surface temperatures as the growth temperature of the crucible may be 2100 °C to 2450 °C and the growth pressure thereof may be 1 Torr to 50 Torr. More specifically, the upper and lower surface temperatures as the growth temperature of the crucible may be 2150 °C to 2450 °C and the growth pressure thereof may be 1 Torr to 40 Torr.

More specifically, the upper and lower surface temperatures as the growth temperature of the crucible may be 2150 °C to 2350 °C and the growth pressure thereof may be 1 Torr to 30 Yorr.

The manufacturing method of the present invention can more advantageously manufacture a higher-quality silicon carbide ingot by applying the crystal growth atmosphere described above.

The silicon carbide ingot 12 contains 4H SiC and may have a convex or flat surface.

If the surface of the silicon carbide ingot 12 is formed in a concave shape, other polytypes, such as 6H-SiC, in addition to the intended 4H-SiC crystal may be mixed, which may degrade the quality of the silicon carbide ingot. In addition, the surface of the silicon carbide ingot is formed in an excessively convex shape, cracks may occur in the ingot itself or crystals may be broken when processed into wafers.

Here, whether the silicon carbide ingot 12 is an excessively convex ingot is determined based on the degree of warp, and a silicon carbide ingot manufactured in this specification has a warp of about 20 mm or less.

The warp is evaluated as a value of (center height - edge height) by placing a sample, on which the growth of a silicon carbide ingot is completed, on a surface plate and measuring the heights of the center and edge of the ingot based on the back of the ingot with a height gauge. A positive value of warp means convex, a value of 0 means flat, and a negative value means concave.

Specifically, the silicon carbide ingot 12 may have a convex or flat surface and a warp of 0 mm to about 14 mm, a warp of about 0 mm to about 11 mm, or a warp of about 0 mm to about 8. A silicon carbide ingot with such a warp degree can make wafer processing easier and reduce the occurrence of cracks.

The silicon carbide ingot 12 may be a 4H-SiC ingot that is a substantially single crystal with minimized defects or polymorphic mixing. The silicon carbide ingot 12 may be formed of substantially 4H-SiC and may have a convex or flat surface.

The silicon carbide ingot 12 may have a reduced number of defects of the type that can occur in a silicon carbide ingot, and thus provide a higher-quality silicon carbide wafer.

The silicon carbide ingot manufactured by the method of the present specification may reduce the pit density on the surface thereof. Specifically, the pit density (included in the surface of an ingot with a diameter of 4 inches or more) may be about $10,000g/cm^2$ or less.

In this specification, to evaluate the surface pit of the silicon carbide ingot, a total of 5 locations, i.e., one location in the center of the ingot surface excluding facets and four locations at 3 o'clock, 6 o'clock, 9 o'clock, and 12 o'clock directions located approximately 10 mm inside from the edge of the silicon carbide ingot toward the center, is observed with an optical microscope, and the pit per unit area ($1 cm^2$) is measured at each location, and the average value thereof is obtained.

For example, the outer rim of the silicon carbide ingot may be trimmed using external grinding equipment, sliced to a certain thickness, and subjected to processing such as edge grinding, surface polishing, and polishing.

The slicing operation is an operation of preparing a sliced crystal by slicing a silicon carbide ingot to have a certain off-angle. The off-angle is based on the (0001) plane in 4H SiC. The off-angle may be an angle selected from specifically 0 to 15 degrees, 0 to 12 degrees, or 0 to 8 degrees.

The slicing may be applied if it is a slicing method normally applied to wafer manufacturing, and exemplarily, cutting using a diamond wire or a wire to which diamond slurry is applied, cutting using a blade or wheel to which diamond is partially applied, etc. may be applied, without being limited thereto.

The thickness of the sliced crystal may be adjusted in consideration of the thickness of the wafer to be manufactured, and the sliced crystal may be sliced to an appropriate thickness in consideration of the thickness after polishing in a polishing operation described below.

The polishing operation is an operation of forming a silicon carbide wafer by polishing the sliced crystal to a thickness of 300 to 800 um.

For the polishing operation, a polishing method normally applied to wafer manufacturing may be applied, and exemplarily, a method in which lapping and/or grinding, etc. are performed, followed by polishing, etc. may be applied.

In the silicon carbide powder according to one embodiment, a mass ratio of particles having a particle diameter of less than 50 $\mu$m after sonication is 10 Wt% or less. In addition, in the silicon carbide powder according to onee embodiment, a mass ratio of particles having a particle diameter of less than 10 $\mu$m after sonication may be about 3 wt% or less. In addition, in the silicon carbide powder according to another embodiment, a mass ratio of particles having a particle diameter of less than 5 $\mu$m after sonication may be 2 wt% or less.

Accordingly, the silicon carbide powder according to one embodiment may be filled into a crucible to manufacture a silicon carbide ingot and a silicon carbide wafer. In addition, since the silicon carbide powder according to one embodiment has a particle diameter distribution after appropriate sonication as described above, it may have an appropriate porosity when filled in the crucible.

In addition, since the silicon carbide powder according to one embodiment has a particle diameter distribution after appropriate sonication as described above, it may prevent fine particles from being attached to a seed tablet when a silicon carbide ingot according to this embodiment grows. Accordingly, the silicon carbide powder according to this embodiment may prevent defects from occurring in the silicon carbide ingot.

That is, since the silicon carbide powder according to one embodiment hardly contains fine cracks, no fine powder is generated from the silicon carbide powder even if a growth temperature rises when the silicon carbide ingot is grown. Accordingly, the silicon carbide powder according to one embodiment may prevent defects caused by fine powder in a silicon carbide wafer.

Hereinafter, various embodiments will be specifically described through specific examples. The following examples are merely examples to aid understanding of the embodiment, and the scope of the present disclosure herein is not limited thereto.

Manufacturing Example 1

A monocrystalline silicon carbide lump was provided as a silicon carbide raw material. The monocrystalline silicon carbide lump may be formed by sublimating a silicon carbide powder with a purity of about 99.9999% or more at about 2300 °C and depositing it on a seed tablet.

The monocrystalline silicon carbide lump was first crushed by a jaw crusher (Henan Dewo Industrial Limited Company, KER-100 × 60). A primary powder having an average particle diameter (D50) of about 6 mm was obtained from the crushed silicon carbide lump.

Next, the primary powder was secondarily pulverized by a ball mill (Ganzhou Li Ang Machinery Co., Ltd., QM400 * 600). Here, a steel ball with a diameter of about 25.4 mm was placed in a cylinder, and the diameter of the cylinder was about 400 mm. In addition, the rotation speed of the cylinder was about 20 rpm, and the secondary pulverization process was carried out for about 15 minutes. The secondarily pulverized primary powder was classified with a classifier, and a secondary powder having an average particle diameter (D50) of about 500 μm was obtained.

Next, the secondary powder was heat treated for about 24 hours at about 1200 °C in an air atmosphere, thereby removing free carbon and free silicon.

Next, the thermally treated silicon carbide powder was added to about 10 ℓ of deionized water in a volume ratio of about 1:1. Next, ultrasonic waves having a frequency of about 40 kHz and an output of about 2000 W were applied to the immersed silicon carbide powder for about 10 minutes. Next, the sonicated silicon carbide powder was filtered with a 300a mesh filter.

Next, the sonicated silicon carbide powder was purified by a wet-etching process.

An etchant was prepared by mixing deionized water, hydrofluoric acid and nitric acid in a volume ratio of about 2:1:1.

Next, about 1 ℓ of the thermally treated silicon carbide powder was put into an etching container having a volume of about 5 ℓ, and about 0.8 ℓ of the etchant was added.

Next, the etching container was sealed with a lid. Here, an oil vapor generated in the etching container was discharged through the lid, and the oil vapor was recovered by the scrubber.

The etchant and the thermally treated silicon carbide powder were stirred for about 1 hour at a speed of about 26 rpm.

Next, the etchant was drained, and the wet-etched silicon carbide powder was neutralized by deionized water in the following process. The wet-etched silicon carbide powder was immersed in deionized water and, after stirring, the deionized water was discharged. The immersion and discharge processes were repeated until the pH of the discharged deionized water reached 7.

Next, the neutralized silicon carbide powder was dried at about 80°C for about 30 minutes.

Next, the dried silicon carbide powder was placed in a graphite crucible.

Next, an inner temperature of the crucible was elevated up to about 2000 °C, and the pressure inside the crucible was reduced to about 8 torr.

Next, an etching gas in which an argon gas and a chlorine gas were mixed in a volume ratio of about 10 : 1 was added into the crucible, and the pressure inside the crucible was elevated to about 760 Torr. Here, the temperature of the crucible was set so that the temperature of a lower part of the crucible was about 50 °C higher than the temperature of an upper part of the crucible. This condition was maintained for about 2 days.

Next, an etching gas inside the crucible was recovered with a scrubber, and the inside of the crucible where the dry-etched silicon carbide powder was disposed was thermally treated at about 1000 °C in an air atmosphere for about 10 hours.

Next, the thermally treated silicon carbide powder was immersed in an aqueous hydrofluoric acid solution at a concentration of about 0.5 wt%, and the silicon carbide powder and the aqueous hydrofluoric acid solution were stirred for about 1 hour.

Next, the silicon carbide powder treated with the aqueous hydrofluoric acid solution was immersed in ultrapure water and washed by repeating the process in which the ultrapure water was drained. Here, the immersion process and the draining process were repeated until the concentration of hydrofluoric acid included in the drained ultrapure water was lowered to about 0.0001 wt% or less.

Manufacturing Examples 2 to 6

A primary crushing process and a secondary pulverization process were substantially the same as those of Manufacturing Example 1 and performed as in Table 1 below.

Table 1

| Classification | Average particle diameter (D50, mm) of primary powder | Ball diameter (mm) | Number of cylinder revolutions (rpm) | Time (min) of second pulverization | Average particle diameter (D50, $\mu$m) of secondary powder |
|---|---|---|---|---|---|
| Manufacturing Example 1 | 6 | 25.4 | 20 | 35 | 150 |
| Manufacturing Example 2 | 6 | 25.4 | 20 | 15 | 500 |
| Manufacturing Example 3 | 6 | 25.4 | 20 | 10 | 1000 |
| Manufacturing Example 4 | 10 | 37 | 20 | 10 | 2000 |
| Manufacturing Example 5 | 10 | 25.4 | 20 | 10 | 3000 |
| Manufacturing Example 6 | 8 | 37 | 25 | 20 | 450 |

As shown in Tables 2 to 5 below, the 2D image analysis, repose angle, and tap density of the silicon carbide powder of each of Manufacturing Examples 1 to 6 and the content of fine particles therein before and after sonication were measured. In the following Table 5, the silicon carbide powder manufactured in each of Manufacturing Examples 1 to 6 was sonicated by the method described in the measurement example below, and the content of fine particles therein was measured.

Table 2

| Classification | Repose angle (°) | Tap density (kg/ m$^3$) |
|---|---|---|
| Manufacturing Example 1 | 29.5 | 1550 |
| Manufacturing Example 2 | 33.4 | 1705 |
| Manufacturing Example 3 | 35.3 | 1629 |
| Manufacturing Example 4 | 36.5 | 1610 |
| Manufacturing Example 5 | 35.1 | 1740 |
| Manufacturing Example 6 | 34.5 | 1650 |

Table 3

| Classification | Particle circularity | Particle elongation | Particle convexity |
|---|---|---|---|
| Manufacturing Example 1 | 0.670 | 0.862 | 0.939 |
| Manufacturing Example 2 | 0.617 | 0.816 | 0.940 |
| Manufacturing Example 3 | 0.615 | 0.891 | 0.879 |
| Manufacturing Example 4 | 0.613 | 0.872 | 0.875 |
| Manufacturing Example 5 | 0.657 | 0.905 | 0.891 |

(continued)

| Classification | Particle circularity | Particle elongation | Particle convexity |
|---|---|---|---|
| Manufacturing Example 6 | 0.662 | 0.875 | 0.938 |

Table 4

| Classification | Content (before sonication, wt%) of particles having particle diameter of less than 50 μm | Content (before sonication, wt%) of particles having particle diameter of less than 10 μm | Content (before sonication, wt%) of particles having particle diameter of less than 5 μm |
|---|---|---|---|
| Manufacturing Example 1 | 9.5 | 2.5 | 1.5 |
| Manufacturing Example 2 | 4.2 | 1.3 | 0.4 |
| Manufacturing Example 3 | 3.4 | 1.0 | 0.2 |
| Manufacturing Example 4 | 3.0 | 0.8 | 0.1 |
| Manufacturing Example 5 | 2.5 | 0.8 | 0.1 |
| Manufacturing Example 6 | 4.1 | 1.3 | 0.5 |

Table 5

| Classification | Content (after sonication, wt%) of particles having particle diameter of less than 50 μm | Content (after sonication, wt%) of particles having particle diameter of less than 10 μm | Content (after sonication, wt%) of particles having particle diameter of less than 5 μm |
|---|---|---|---|
| Manufacturing Example 1 | 9.5 | 2.5 | 1.6 |
| Manufacturing Example 2 | 4.2 | 1.3 | 0.4 |
| Manufacturing Example 3 | 3.3 | 1.1 | 0.2 |
| Manufacturing Example 4 | 3.0 | 0.8 | 0.1 |
| Manufacturing Example 5 | 2.5 | 0.8 | 0.1 |
| Manufacturing Example 6 | 4.1 | 1.3 | 0.5 |

Examples

Next, the silicon carbide powder manufactured in Manufacturing Example 1 was loaded into a graphite crucible body. A silicon carbide seed tablet and a seed tablet holder were placed on the top of the powder. Here, the C surface (0001) of the silicon carbide seed tablet (4H-SiC single crystal, 6 inches) was fixed in a general method to face the bottom of the crucible. In addition, a crucible cover and a seed tablet holder were integrally formed with graphite, and both the crucible cover and the seed tablet holder had a disc shape. Here, the thickness of the crucible cover was about 20 mm, the diameter of the crucible cover was about 210 mm, the thickness of the seed tablet holder was about 3 mm, and the diameter of the seed tablet holder was about 180 mm.

The crucible main body was covered with a crucible cover in which the seed tablet and the seed tablet holder were installed, surrounded by an insulator, and placed in a reaction chamber equipped with a heating coil 50 as a heating device.

Here, a graphite felt having a density of about 0.19 g/cc, a porosity of about 85 vol%, and a compressive strength of about 0.37 MPa was applied as an insulator.

After evacuating the inside of the crucible, argon gas was slowly injected thereinto so that the inside of the crucible reached atmospheric pressure, and then the inside of the crucible was gradually decompressed. At the same time, the temperature inside the crucible was gradually elevated up to 2000 °C at a heating rate of about 3 °C/min and gradually elevated to 2350 °C at a heating rate of about 5 °C/min.

Next, a SiC ingot was grown from a silicon carbide seed tablet for 100 hours under conditions of 2350 °C and a pressure of 20 Torr.

Next, the silicon carbide ingot was cut by a diamond wire saw and processed by chamfering, grinding and polishing processes. Accordingly, a silicon carbide wafer with an angle-off of 4 degrees with respect to the (0001) plane was manufactured.

Examples 2 to 7 and Comparative Example

As shown in Table 6 below, experiments were carried out in the same manner as in Example 1 except that the silicon carbide powder was changed.

Table 6

| Classification | a silicon carbide powder | Bulk density (kg/ $m^3$) | Porosity (vol%) |
|---|---|---|---|
| Example 1 | Manufacturing Example 1 | 1440 | 48.2 |
| Example 2 | Manufacturing Example 2 | 1689 | 47.5 |
| Example 3 | Manufacturing Example 3 | 1518 | 48.8 |
| Example 4 | Manufacturing Example 4 | 1493 | 48.1 |
| Example 5 | Manufacturing Example 5 | 1625 | 47.8 |
| Example 6 | Manufacturing Example 6 | 1544 | 48.5 |
| Comparative example | Carborex manufactured by Washington Mills | 1525 | 48.3 |

[Table 7]

| Classification | Growth rate ($\mu$m/hr) | Defect (EPD/$cm^2$) |
|---|---|---|
| Example 1 | 280 | 9920 |
| Example 3 | 282 | 7820 |
| Example 4 | 271 | 9620 |
| Example 5 | 268 | 14340 |
| Example 6 | 275 | 14920 |
| Example 7 | 271 | 13760 |
| Comparative example | 250 | 16354 |

Measurement examples

1. Purity of silicon carbide powder

The purity of the silicon carbide powder according to the manufacturing example was measured by glow discharge mass spectrometry.

2. Shape of silicon carbide powder

About 1 g of the silicon carbide powder manufactured in the manufacturing example was sampled about 30 times. The samples were taken by an optical microscope (Eclipse LV150 Microscope, manufactured by Nikon) and analyzed by an image analysis program (i-solution, manufactured by IMT). The area, perimeter, equivalent circle diameter, maximum ellipse diameter, minimum ellipse diameter, maximum length, maximum frame diameter, minimum frame diameter, middle frame diameter and convex hull of each particle were measured. Respective values measured from each particle were derived as an average value.

3. Repose angle

The silicon carbide powder according to the embodiment was poured onto a circular plate having a diameter of about 100 mm, and the silicon carbide powder according to the embodiment was deposited in a conical shape to form a sedimentary layer. The repose angle may be an angle between the horizontal plane and the slope of the sedimentary layer. The repose angle was measured using Powder Flow Tester manufactured by Brookfield.

4. Tap density

About 100 g of the silicon carbide powder according to the embodiment was filled into a 250 ml cylinder. Next, the cylinder was tapped until the volume of the silicon carbide powder according to the embodiment was reduced to about 2%. Here, the apparent density of the silicon carbide powder according to the embodiment may be the tap density. The tap density was measured using Powder Flow Tester manufactured by Brookfield.

5. Sonication condition

About 100 g of the silicon carbide powder manufactured in the manufacturing example was added to ultrapure water, and ultrasonic waves having a frequency of about 40 kHz and an output of about 1200 W were applied to the immersed silicon carbide powder for about 5 minutes. Next, the ultrapure water was removed by a drying process so that a sonicated silicon carbide powder was obtained.

6. Diameter and content of silicon carbide particles

About 100 g of the silicon carbide powder manufactured in the manufacturing example was classified by a 100 $\mu$m mesh, and the particles that had passed through the mesh were dispersed in ultrapure water, and the particle diameter and content were measured by a particle size meter (Mastersizer 3000, manufactured by Malvern). Accordingly, particle diameter-dependent contents were derived.

As shown in Table 6, since the silicon carbide powders manufactured according to the examples have a particle circularity, particle convexity, particle elongation, repose angle, tap density and fine particle content in appropriate ranges, a silicon carbide ingot with a high growth rate and low defects can be manufactured.

Description of Symbols

crucible body 20
insulator 40
silicon carbide ingot 12

**Claims**

1. A silicon carbide powder comprising:

   silicon carbide particles comprising carbon and silicon,
   wherein a mass ratio of a mass of silicon carbide particles having a particle diameter of less than 50 $\mu$m after sonication to a total mass of the silicon carbide particles is 10 wt% or less.

2. The silicon carbide powder according to claim 1, wherein a mass ratio a mass of silicon carbide particles having a particle diameter of less than 10 μm after sonication to the total mass of the silicon carbide particles is 3 wt% or less.

3.  The silicon carbide powder according to claim 2, wherein a mass ratio a mass of silicon carbide particles having a particle diameter of less than 5 μm after sonication to the total mass of the silicon carbide particles is 2 wt% or less.

4.  The silicon carbide powder according to claim 2, wherein the silicon carbide powder has an average particle diameter (D50) of 100 μm to 5000 μm.

5.  The silicon carbide powder according to claim 1, wherein a particle circularity measured through 2D image analysis is 0.4 to 0.9.

6.  The silicon carbide powder according to claim 5, wherein a particle convexity measured through the 2D image analysis is 0.8 to 0.99.

7.  The silicon carbide powder according to claim 1, wherein the silicon carbide powder has a repose angle of 30° to 45°.

8.  The silicon carbide powder according to claim 1, wherein the silicon carbide powder has a tap density of 1000 kg/m$^3$ to 2000 kg/m$^3$.

FIG. 1

```
┌─────────────────────────────────────────────────┐
│      CRUSH SILICON CARBIDE RAW MATERIAL          │──── S10
└─────────────────────────────────────────────────┘
                        │
                        ▼
┌─────────────────────────────────────────────────┐
│         REMOVE CARBON-BASED MATERIAL             │──── S20
└─────────────────────────────────────────────────┘
                        │
                        ▼
┌─────────────────────────────────────────────────┐
│     PULVERIZE SILICON CARBIDE RAW MATERIAL       │──── S30
└─────────────────────────────────────────────────┘
                        │
                        ▼
┌─────────────────────────────────────────────────┐
│  PHYSICALLY PROCESS SILICON CARBIDE RAW MATERIAL │──── S40
└─────────────────────────────────────────────────┘
                        │
                        ▼
┌─────────────────────────────────────────────────┐
│     WET-ETCH SILICON CARBIDE RAW MATERIAL        │──── S50
└─────────────────────────────────────────────────┘
                        │
                        ▼
┌─────────────────────────────────────────────────┐
│     DRY-ETCH SILICON CARBIDE RAW MATERIAL        │──── S60
└─────────────────────────────────────────────────┘
                        │
                        ▼
┌─────────────────────────────────────────────────┐
│       WASH SILICON CARBIDE RAW MATERIAL          │──── S70
└─────────────────────────────────────────────────┘
                        │
                        ▼
┌─────────────────────────────────────────────────┐
│     CLASSIFY SILICON CARBIDE RAW MATERIAL        │──── S80
└─────────────────────────────────────────────────┘
```

FIG. 2

```
┌─────────────────────────────────────────────────┐
│          REMOVE CARBON-BASED MATERIAL           │──── S1
└─────────────────────────────────────────────────┘
                        │
                        ▼
┌─────────────────────────────────────────────────┐
│         CRUSH SILICON CARBIDE RAW MATERIAL       │──── S10
└─────────────────────────────────────────────────┘
                        │
                        ▼
┌─────────────────────────────────────────────────┐
│       PULVERIZE SILICON CARBIDE RAW MATERIAL     │──── S30
└─────────────────────────────────────────────────┘
                        │
                        ▼
┌─────────────────────────────────────────────────┐
│       WET-ETCH SILICON CARBIDE RAW MATERIAL      │──── S50
└─────────────────────────────────────────────────┘
                        │
                        ▼
┌─────────────────────────────────────────────────┐
│   PHYSICALLY PROCESS SILICON CARBIDE RAW MATERIAL │──── S51
└─────────────────────────────────────────────────┘
                        │
                        ▼
┌─────────────────────────────────────────────────┐
│       DRY-ETCH SILICON CARBIDE RAW MATERIAL      │──── S60
└─────────────────────────────────────────────────┘
                        │
                        ▼
┌─────────────────────────────────────────────────┐
│         WASH SILICON CARBIDE RAW MATERIAL        │──── S70
└─────────────────────────────────────────────────┘
                        │
                        ▼
┌─────────────────────────────────────────────────┐
│       CLASSIFY SILICON CARBIDE RAW MATERIAL      │──── S80
└─────────────────────────────────────────────────┘
```

FIG. 3

```
┌─────────────────────────────────────────────┐
│     CRUSH SILICON CARBIDE RAW MATERIAL       │ ─── S10
└─────────────────────────────────────────────┘
                      ↓
┌─────────────────────────────────────────────┐
│    PULVERIZE SILICON CARBIDE RAW MATERIAL    │ ─── S30
└─────────────────────────────────────────────┘
                      ↓
┌─────────────────────────────────────────────┐
│    WET-ETCH SILICON CARBIDE RAW MATERIAL     │ ─── S50
└─────────────────────────────────────────────┘
                      ↓
┌─────────────────────────────────────────────┐
│    DRY-ETCH SILICON CARBIDE RAW MATERIAL     │ ─── S60
└─────────────────────────────────────────────┘
                      ↓
┌─────────────────────────────────────────────┐
│      WASH SILICON CARBIDE RAW MATERIAL       │ ─── S70
└─────────────────────────────────────────────┘
                      ↓
┌─────────────────────────────────────────────┐
│  PHYSICALLY PROCESS SILICON CARBIDE RAW MATERIAL │ ─── S71
└─────────────────────────────────────────────┘
                      ↓
┌─────────────────────────────────────────────┐
│    CLASSIFY SILICON CARBIDE RAW MATERIAL     │ ─── S80
└─────────────────────────────────────────────┘
```

FIG. 4

CRUSH SILICON CARBIDE RAW MATERIAL — S10

REMOVE CARBON-BASED MATERIAL — S20

PULVERIZE SILICON CARBIDE RAW MATERIAL — S30

PHYSICALLY PROCESS SILICON CARBIDE RAW MATERIAL — S31

CLASSIFY SILICON CARBIDE RAW MATERIAL — S32

WET-ETCH SILICON CARBIDE RAW MATERIAL — S50

DRY-ETCH SILICON CARBIDE RAW MATERIAL — S60

WASH SILICON CARBIDE RAW MATERIAL — S70

FIG. 5

```
┌─────────────────────────────────────────────────┐
│         REMOVE CARBON-BASED MATERIAL            │──╮ S1
└─────────────────────────────────────────────────┘
                        │
                        ▼
┌─────────────────────────────────────────────────┐
│         CRUSH SILICON CARBIDE RAW MATERIAL      │──╮ S10
└─────────────────────────────────────────────────┘
                        │
                        ▼
┌─────────────────────────────────────────────────┐
│       PULVERIZE SILICON CARBIDE RAW MATERIAL    │──╮ S30
└─────────────────────────────────────────────────┘
                        │
                        ▼
┌─────────────────────────────────────────────────┐
│   PHYSICALLY PROCESS SILICON CARBIDE RAW MATERIAL│──╮ S31
└─────────────────────────────────────────────────┘
                        │
                        ▼
┌─────────────────────────────────────────────────┐
│       CLASSIFY SILICON CARBIDE RAW MATERIAL     │──╮ S32
└─────────────────────────────────────────────────┘
                        │
                        ▼
┌─────────────────────────────────────────────────┐
│       WET-ETCH SILICON CARBIDE RAW MATERIAL     │──╮ S50
└─────────────────────────────────────────────────┘
                        │
                        ▼
┌─────────────────────────────────────────────────┐
│       DRY-ETCH SILICON CARBIDE RAW MATERIAL     │──╮ S60
└─────────────────────────────────────────────────┘
                        │
                        ▼
┌─────────────────────────────────────────────────┐
│        WASH SILICON CARBIDE RAW MATERIAL        │──╮ S70
└─────────────────────────────────────────────────┘
```

FIG. 6

```
┌─────────────────────────────────────────────────┐
│        CRUSH SILICON CARBIDE RAW MATERIAL        │ ⟋ S10
└─────────────────────────────────────────────────┘
                        │
                        ▼
┌─────────────────────────────────────────────────┐
│      PULVERIZE SILICON CARBIDE RAW MATERIAL      │ ⟋ S30
└─────────────────────────────────────────────────┘
                        │
                        ▼
┌─────────────────────────────────────────────────┐
│  PHYSICALLY PROCESS SILICON CARBIDE RAW MATERIAL │ ⟋ S31
└─────────────────────────────────────────────────┘
                        │
                        ▼
┌─────────────────────────────────────────────────┐
│      CLASSIFY SILICON CARBIDE RAW MATERIAL       │ ⟋ S32
└─────────────────────────────────────────────────┘
                        │
                        ▼
┌─────────────────────────────────────────────────┐
│      WET-ETCH SILICON CARBIDE RAW MATERIAL       │ ⟋ S50
└─────────────────────────────────────────────────┘
                        │
                        ▼
┌─────────────────────────────────────────────────┐
│      DRY-ETCH SILICON CARBIDE RAW MATERIAL       │ ⟋ S60
└─────────────────────────────────────────────────┘
                        │
                        ▼
┌─────────────────────────────────────────────────┐
│        WASH SILICON CARBIDE RAW MATERIAL         │ ⟋ S70
└─────────────────────────────────────────────────┘
```

FIG. 7

Europäisches
Patentamt

European
Patent Office

Office européen
des brevets

# EUROPEAN SEARCH REPORT

Application Number

EP 23 19 2538

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2018 104216 A (TAIHEIYO CEMENT CORP) 5 July 2018 (2018-07-05) | 1-4,7,8 | INV. C01B32/956 C01B32/97 |
| A | * examples 1-3; table 1 * | 5,6 | |
| X | YUN SUNG IL ET AL: "Effects of SiC particle size on flexural strength, permeability, electrical resistivity, and thermal conductivity of macroporous SiC", CERAMICS INTERNATIONAL, ELSEVIER, AMSTERDAM, NL, vol. 48, no. 1, 2 October 2021 (2021-10-02), pages 1429-1438, XP086865537, ISSN: 0272-8842, DOI: 10.1016/J.CERAMINT.2021.09.244 [retrieved on 2021-10-02] | 1-4 | |
| A | * "methods and materials", "Results and discussion"; figure 1; table 1 * | 5-8 | |
| A | EP 3 763 852 A1 (SKC CO LTD [KR]) 13 January 2021 (2021-01-13) * paragraphs [0334] - [0104]; tables 1-3 * | 1-8 | **TECHNICAL FIELDS SEARCHED (IPC)** C01B |

The present search report has been drawn up for all claims

| Place of search | Date of completion of the search | Examiner |
|---|---|---|
| The Hague | 12 February 2024 | Corrias, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 19 2538

This annex lists the patent family members relating to the patent documents cited in the above-mentioned European search report.
The members are as contained in the European Patent Office EDP file on
The European Patent Office is in no way liable for these particulars which are merely given for the purpose of information.

12-02-2024

| Patent document cited in search report | | Publication date | Patent family member(s) | | Publication date |
|---|---|---|---|---|---|
| JP 2018104216 | A | 05-07-2018 | JP | 6778100 B2 | 28-10-2020 |
| | | | JP | 2018104216 A | 05-07-2018 |
| EP 3763852 | A1 | 13-01-2021 | CN | 112210824 A | 12-01-2021 |
| | | | EP | 3763852 A1 | 13-01-2021 |
| | | | JP | 6758527 B1 | 23-09-2020 |
| | | | JP | 2021014395 A | 12-02-2021 |
| | | | KR | 102068933 B1 | 21-01-2020 |
| | | | TW | 202102730 A | 16-01-2021 |
| | | | US | 10822720 B1 | 03-11-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002326876 A